(19) **Europäisches Patentamt / European Patent Office / Office européen des brevets**

(11) **EP 4 475 421 A1**

(12) **EUROPEAN PATENT APPLICATION**
published in accordance with Art. 153(4) EPC

(43) Date of publication:
**11.12.2024 Bulletin 2024/50**

(21) Application number: **23749510.6**

(22) Date of filing: **17.01.2023**

(51) International Patent Classification (IPC):
***H02M 7/48*** (2007.01)

(52) Cooperative Patent Classification (CPC):
**H02M 7/48**

(86) International application number:
**PCT/JP2023/001144**

(87) International publication number:
**WO 2023/149193 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.02.2022 JP 2022015216**

(71) Applicant: **Panasonic Intellectual Property Management Co., Ltd.**
**Osaka-shi, Osaka 540-6207 (JP)**

(72) Inventors:
• **MAEDA, Ryosuke**
 **Kadoma-shi, Osaka 571-0057 (JP)**
• **HIGASHIYAMA, Koji**
 **Kadoma-shi, Osaka 571-0057 (JP)**

(74) Representative: **Novagraaf International SA**
**Chemin de l'Echo 3**
**1213 Onex, Geneva (CH)**

(54) **POWER CONVERSION DEVICE**

(57) Disclosed herein is a technique for reducing radiation noise. In a bidirectional switch (8) of a power converter (100), a first terminal (81) thereof is connected to a connection node (3) between a first switching element (1) and a second switching element (2). A resonant capacitor (9) is connected between the first terminal (81) of the bidirectional switch (8) and a second DC terminal (32). A resonant inductor (L1) is connected to a second terminal (82) of the bidirectional switch (8). A regenerative element (12) is connected between the resonant inductor (L1) and the second DC terminal (32). A first control unit (51) controls the first switching element (1) and the second switching element (2). A second control unit (52) controls the bidirectional switch (8). A limiter (15) limits the absolute value of a voltage variation rate of a voltage applied between the first and second terminals (81, 82) of the bidirectional switch (8) to a threshold value or less.

*FIG. 1*

**EP 4 475 421 A1**

## Description

### Technical Field

The present disclosure generally relates to a power converter. More particularly, the present disclosure relates to a power converter having the ability to convert DC power into AC power.

### Background Art

Patent Literature 1 discloses a power converter for converting DC power into AC power by switching.

The power converter of Patent Literature 1 includes: a switching means (power converter circuit) including a pair of main switch elements (first switching element and second switching element) which are connected to each other in series; and diodes (first diode and second diode) connected in antiparallel to the respective main switch elements. The power converter further includes an auxiliary circuit for making soft switching of the respective main switch elements. The auxiliary circuit includes two capacitors, a coil (resonant inductor), and a bidirectional switch.

When making soft switching of the first switching element and the second switching element, the power converter may cause an increase in radiation noise compared to when making no soft switching.

### Citation List

### Patent Literature

Patent Literature 1: JP 2010-233306 A

### Summary of Invention

An object of the present disclosure is to provide a power converter having the ability to reduce the radiation noise.

A power converter according to an aspect of the present disclosure includes a first DC terminal and a second DC terminal, a power converter circuit, a bidirectional switch, a resonant capacitor, a resonant inductor, a regenerative element, a first control unit, a second control unit, and a limiter. The power converter circuit includes: a first switching element and a second switching element which are connected to each other in series; a first diode connected in antiparallel to the first switching element; and a second diode connected in antiparallel to the second switching element. In the power converter circuit, the first switching element is connected to the first DC terminal and the second switching element is connected to the second DC terminal. The bidirectional switch has a first terminal and a second terminal. The bidirectional switch has the first terminal connected to a connection node between the first switching element and the second switching element. The resonant capacitor is connected between the first terminal of the bidirectional switch and the second DC terminal. The resonant inductor is connected to the second terminal of the bidirectional switch. The regenerative element is connected between the resonant inductor and the second DC terminal. The first control unit controls the first switching element and the second switching element. The second control unit controls the bidirectional switch. The limiter limits an absolute value of a voltage variation rate of a voltage applied between the first and second terminals of the bidirectional switch to a threshold value or less.

Brief Description of Drawings

FIG. 1 is a circuit diagram of a system including a power converter according to a first embodiment;
FIG. 2 illustrates how the power converter operates;
FIG. 3 is an equivalent circuit diagram of an auxiliary circuit and a second control unit included in the power converter;
FIG. 4 illustrates how the power converter operates;
FIG. 5A is a characteristic diagram showing results of measurement of horizontal polarized wave radiation noise produced by an example and a comparative example of the power converter;
FIG. 5B is a characteristic diagram showing results of measurement of vertical polarized wave radiation noise produced by an example and a comparative example of the power converter;
FIG. 6 is a circuit diagram of a system including a power converter according to a second embodiment;
FIG. 7 is an equivalent circuit diagram of an auxiliary circuit and a second control unit included in the power converter;
FIG. 8 illustrates how the power converter operates;
FIG. 9 is a circuit diagram of a system including a power converter according to a third embodiment;

FIG. 10 is an equivalent circuit diagram of an auxiliary circuit included in the power converter;

FIG. 11 illustrates how the power converter operates;

FIG. 12 is a circuit diagram of a system including a power converter according to a fourth embodiment;

FIG. 13 is a circuit diagram of a system including a power converter according to a fifth embodiment;

FIG. 14 is a circuit diagram of a system including a power converter according to a sixth embodiment;

FIG. 15 is a characteristic diagram of a resonant inductor included in the power converter;

FIG. 16 illustrates a schematic configuration for the resonant inductor included in the power converter;

FIG. 17 illustrates how the power converter operates;

FIG. 18 illustrates an alternative configuration for the resonant inductor included in the power converter;

FIG. 19 is a circuit diagram of a system including a power converter according to a seventh embodiment;

FIG. 20 illustrates how the power converter operates;

FIG. 21 illustrates how a comparative example of the power converter operates;

FIG. 22 is a circuit diagram of a system including a power converter according to an eighth embodiment;

FIG. 23 is a circuit diagram of a system including a power converter according to a ninth embodiment;

FIG. 24 is a circuit diagram of a system including a power converter according to a tenth embodiment;

FIG. 25 is a circuit diagram of a system including a power converter according to an eleventh embodiment;

FIG. 26 is a circuit diagram of a system including a power converter according to a twelfth embodiment;

FIG. 27 is a circuit diagram of a system including a power converter according to a thirteenth embodiment;

FIG. 28 illustrates how the power converter operates;

FIG. 29 illustrates how the power converter operates;

FIG. 30 shows how duties, respectively corresponding to three-phase voltage commands in an AC load connected to a plurality of AC terminals of the power converter, change with time; and

FIG. 31 is a circuit diagram of a system including a power converter according to a fourteenth embodiment.

## Description of Embodiments

(First embodiment)

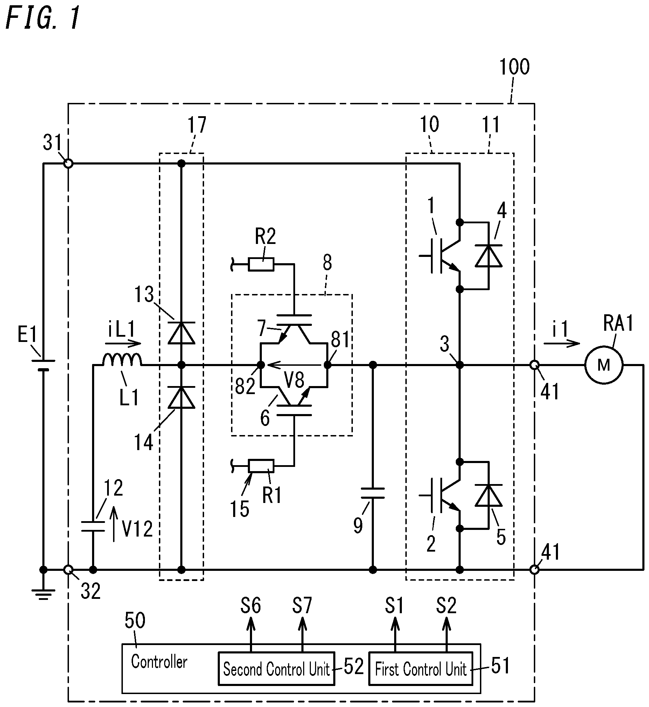

A power converter 100 according to a first embodiment will now be described with reference to FIGS. 1-4.

(1) Overall configuration for power converter

The power converter 100 includes a first DC terminal 31 and a second DC terminal 32, and a plurality of (e.g., two) AC terminals 41 as shown in FIG. 1, for example. A DC power supply E1 is connected between the first DC terminal 31 and the second DC terminal 32. An AC load RA1 is connected to the plurality of AC terminals 41. The AC load RA1 may be, for example, a single-phase motor. The power converter 100 converts the DC power supplied from the DC power supply E1 into AC power and outputs the AC power to the AC load RA1. The DC power supply E1 may include, for example, a solar cell or a fuel cell. The DC power supply E1 may include a DC-DC converter.

The power converter 100 includes a power converter circuit 11, a bidirectional switch 8, a resonant capacitor 9, a resonant inductor L1, a regenerative element 12, and a controller 50. The controller 50 includes a first control unit 51 and a second control unit 52. The power converter circuit 11 includes a first switching element 1 and a second switching element 2. The power converter circuit 11 includes a switching circuit 10 in which the first switching element 1 and the second switching element 2 are connected to each other in series. In the power converter circuit 11, the first switching element 1 is connected to the first DC terminal 31 and the second switching element 2 is connected to the second DC terminal 32. The power converter circuit 11 further includes a first diode 4 connected in antiparallel to the first switching element 1 and a second diode 5 connected in antiparallel to the second switching element 2. The plurality of AC terminals 41 are connected across the second switching element 2. Thus, one AC terminal 41 out of the two AC terminals 41 is connected to the connection node 3 between the first switching element 1 and the second switching element 2. The bidirectional switch 8 has a first terminal 81 and a second terminal 82. The first terminal 81 of the bidirectional switch 8 is connected to the connection node 3 between the first switching element 1 and the second switching element 2. The resonant capacitor 9 is connected between the first terminal 81 of the bidirectional switch 8 and the second DC terminal 32. The resonant inductor L1 is connected to the second terminal 82 of the bidirectional switch 8. The regenerative element 12 is connected between the resonant inductor L1 and the second DC terminal 32. The controller 50 includes the first control unit 51 that controls the first switching element 1 and the second switching element 2 and the second control unit 52 that controls the bidirectional switch 8.

The first control unit 51 allows each of the first switching element 1 and the second switching element 2 to make zero-voltage soft switching.

(2) Details of power converter

As shown in FIG. 1, the power converter 100 includes the first DC terminal 31 and the second DC terminal 32, the power converter circuit 11, the plurality of (e.g., two) AC terminals 41, the bidirectional switch 8, the resonant capacitor 9, the resonant inductor L1, the regenerative element 12, the first control unit 51, the second control unit 52, and a limiter 15. The power converter circuit 11 includes: the first switching element 1 and the second switching element 2 which are connected to each other in series; the first diode 4 connected in antiparallel to the first switching element 1; and the second diode 5 connected in antiparallel to the second switching element 2. The power converter 100 further includes a protection circuit 17.

In the power converter 100, the DC power supply E1 may be connected, for example, between the first DC terminal 31 and the second DC terminal 32. More specifically, in the power converter 100, the higher-potential output terminal (positive electrode) of the DC power supply E1 is connected to the first DC terminal 31, and the lower-potential output terminal (negative electrode) of the DC power supply E1 is connected to the second DC terminal 32. In addition, the AC load RA1 may be connected, for example, between the two AC terminals 41.

In the power converter circuit 11, each of the first switching element 1 and the second switching element 2 has a control terminal, a first main terminal, and a second main terminal. The respective control terminals of the first switching element 1 and the second switching element 2 are connected to the first control unit 51. In the switching circuit 10 of the power converter 100, the first main terminal of the first switching element 1 is connected to the first DC terminal 31, the second main terminal of the first switching element 1 is connected to the first main terminal of the second switching element 2, and the second main terminal of the second switching element 2 is connected to the second DC terminal 32. In the switching circuit 10, the first switching element 1 is a high-side switching element (P-side switching element) and the second switching element 2 is a low-side switching element (N-side switching element). Each of the first switching element 1 and the second switching element 2 may be, for example, an insulated gate bipolar transistor (IGBT). Thus, in each of the first switching element 1 and the second switching element 2, the control terminal, the first main terminal, and the second main terminal are a gate terminal, a collector terminal, and an emitter terminal, respectively. The power converter circuit 11 further includes the first diode 4 connected in antiparallel to the first switching element 1 and the second diode 5 connected in antiparallel to the second switching element 2. In the first diode 4, the anode of the first diode 4 is connected to the second main terminal (emitter terminal) of the first switching element 1, and the cathode of the first diode 4 is connected to the first main terminal (collector terminal) of the first switching element 1. In the second diode 5, the anode of the second diode 5 is connected to the second main terminal (emitter terminal) of the second switching element 2, and the cathode of the second diode 5 is connected to the first main terminal (collector terminal) of the second switching element 2.

The AC load RA1 may be connected to the connection node 3 between the first switching element 1 and the second switching element 2 via the AC terminal 41. The AC load RA1 may be, for example, an inductive load.

The first switching element 1 and the second switching element 2 are controlled by the first control unit 51.

The resonant capacitor 9 is connected between the first terminal 81 of the bidirectional switch 8 and the second DC terminal 32. The power converter 100 includes a resonant circuit. The resonant circuit includes the resonant capacitor 9 and the resonant inductor L1.

The bidirectional switch 8 includes, for example, a third switching element 6 and a fourth switching element 7, which are connected in antiparallel to each other. Each of the third switching element 6 and the fourth switching element 7 may be, for example, an IGBT. Thus, in each of the third switching element 6 and the fourth switching element 7, the control terminal, the first main terminal, and the second main terminal are a gate terminal, a collector terminal, and an emitter terminal, respectively. In the bidirectional switch 8, the first main terminal (collector terminal) of the third switching element 6 and the second main terminal (emitter terminal) of the fourth switching element 7 are connected to each other, and the second main terminal (emitter terminal) of the third switching element 6 and the first main terminal (collector terminal) of the fourth switching element 7 are connected to each other. The third switching element 6 is connected to the connection node 3 of the switching circuit 10. The fourth switching element 7 is also connected to the connection node 3 of the switching circuit 10.

The bidirectional switch 8 is controlled by the second control unit 52. In other words, the third switching element 6 and the fourth switching element 7 are controlled by the second control unit 52.

The resonant inductor L1 has a first terminal and a second terminal. In the resonant inductor L1, the first terminal of the resonant inductor L1 is connected to the second terminal 82 of the bidirectional switch 8 and the second terminal of the resonant inductor L1 is connected to the regenerative element 12.

The regenerative element 12 is connected between the second terminal of the resonant inductor L1 and the second DC terminal 32. The regenerative element 12 may be, for example, a capacitor. The capacitor serving as the regenerative element 12 may be, for example, a film capacitor.

The protection circuit 17 includes a third diode 13 and a fourth diode 14. The third diode 13 is connected between the second terminal 82 of the bidirectional switch 8, the first terminal of the resonant inductor L1, and the first DC terminal 31. In the third diode 13, the anode of the third diode 13 is connected to the second terminal 82 of the bidirectional switch 8 and the first terminal of the resonant inductor L1. In the third diode 13, the cathode of the third diode 13 is connected to the first DC terminal 31. The fourth diode 14 is connected between the second terminal 82 of the bidirectional switch 8, the first terminal of the resonant inductor L1, and the second DC terminal 32. In the fourth diode 14, the anode of the fourth diode 14 is connected to the second DC terminal 32. In the fourth diode 14, the cathode of the fourth diode 14 is connected to the second terminal 82 of the bidirectional switch 8 and the first terminal of the resonant inductor L1. Thus, the fourth diode 14 is connected to the third diode 13 in series.

The controller 50 controls the first switching element 1, the second switching element 2, and the bidirectional switch 8. More specifically, the first control unit 51 of the controller 50 controls the first switching element 1 and the second switching element 2. The second control unit 52 of the controller 50 controls the third switching element 6 and the fourth switching element 7. The agent that performs the functions of the controller 50 includes a computer system. The computer system includes a single computer or a plurality of computers. The computer system may include a processor and a memory as principal hardware components thereof. The computer system serves as the agent that performs the functions of the controller 50 according to the present disclosure by making the processor execute a program stored in the memory of the computer system. The program may be stored in advance in the memory of the computer system. Alternatively, the program may also be downloaded through a telecommunications line or be distributed after having been recorded in a non-transitory storage medium such as a memory card, an optical disc, or a hard disk drive (magnetic disk), any of which is readable for the computer system. The processor of the computer system may be made up of a single or a plurality of electronic circuits including a semiconductor integrated circuit (IC) or a large-scale integrated circuit (LSI). Those electronic circuits may be either integrated together on a single chip or distributed on multiple chips, whichever is appropriate. Those multiple chips may be aggregated together in a single device or distributed in multiple devices without limitation.

The controller 50 outputs a pulse width modulation (PWM) signal S1 to control the ON/OFF states of the first switching element 1. The PWM signal S1 is a signal having, for example, a potential level that alternates between a first potential level (hereinafter referred to as a "low level") and a second potential level (hereinafter referred to as a "high level") higher than the first potential level. The first switching element 1 turns ON when the PWM signal S1 has the high level and turns OFF when the PWM signal S1 has the low level. The controller 50 also outputs a PWM signal S2 to control the ON/OFF states of the second switching element 2. The PWM signal S2 is a signal having, for example, a potential level that alternates between a first potential level (hereinafter referred to as a "low level") and a second potential level (hereinafter referred to as a "high level") higher than the first potential level. The second switching element 2 turns ON when the PWM signal S2 has the high level and turns OFF when the PWM signal S2 has the low level. The controller 50 generates, using a carrier signal having a saw-tooth waveform, the PWM signals S1 for the first switching element 1, and the PWM signal S2 for the second switching element 2. More specifically, the controller 50 generates, based on at least the carrier signal and a voltage command, the PWM signals S1, S2 to be supplied to the first switching element 1 and the second switching element 2, respectively. The voltage command may be, for example, a sinusoidal wave signal, of which the amplitude (voltage command value) changes with time. Also, one cycle of the voltage command is longer than one cycle of the carrier signal.

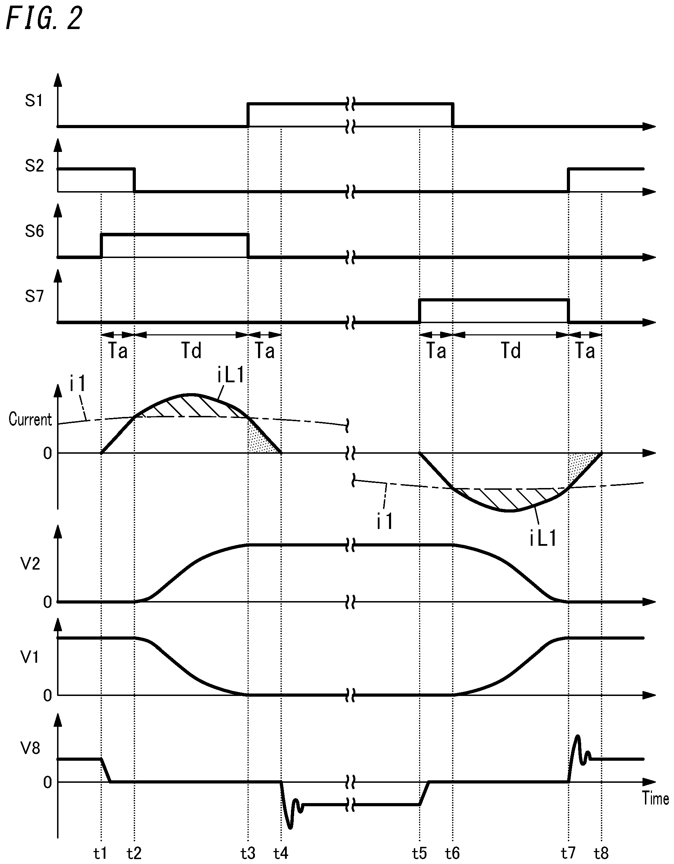

The duty of the PWM signals S1, S2 to be supplied from the controller 50 to the first switching element 1 and the second switching element 2, respectively, varies in accordance with the voltage command. The controller 50 generates the PWM signal S1 to be supplied to the first switching element 1 by comparing the voltage command with the carrier signal. The controller 50 generates the PWM signal S2 to be supplied to the second switching element 2 by inverting the PWM signal S1 to be supplied to the first switching element 1. In addition, to prevent the respective ON periods of the first switching element 1 and the second switching element 2 from overlapping with each other, the controller 50 sets a dead time Td (refer to FIG. 2) between a period in which the PWM signal S1 has high level and a period in which the PWM signal S2 has high level.

The controller 50 generates the respective PWM signals S1, S2 based on the carrier signal, the voltage command, and information about the state of the AC load RA1. For example, if the AC load RA1 is a single-phase motor, the information about the state of the AC load RA1 may include, for example, a detection value provided by a current sensor for detecting a current flowing through the AC load RA1.

The bidirectional switch 8, the resonant inductor L1, the resonant capacitor 9, and the regenerative element 12 are constituent elements of an auxiliary circuit provided for the power converter 100 to make zero-voltage soft switching of the first switching element 1 and the second switching element 2.

In the power converter 100, the controller 50 controls not only the first switching element 1 and second switching element 2 of the power converter circuit 11 but also the bidirectional switch 8 as well.

The controller 50 generates control signals S6, S7 for controlling the respective ON/OFF states of the third switching element 6 and the fourth switching element 7, and outputs the control signals S6, S7 to the respective main terminals (gate terminals) of the third switching element 6 and the fourth switching element 7.

If the third switching element 6 is ON and the fourth switching element 7 is OFF, the bidirectional switch 8 allows a charging current that flows through the regenerative element 12, the resonant inductor L1, the bidirectional switch 8, and the resonant capacitor 9 in this order to charge the resonant capacitor 9 to pass therethrough. On the other hand, if the third switching element 6 is OFF and the fourth switching element 7 is ON, the bidirectional switch 8 allows a discharging current that flows through the resonant capacitor 9, the bidirectional switch 8, the resonant inductor L1, and the regenerative element 12 in this order to remove electric charges from the resonant capacitor 9 to pass therethrough.

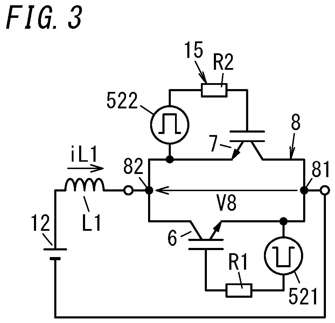

In the power converter 100, the second control unit 52 includes a first drive circuit 521 (refer to FIG. 3) and a second drive circuit 522 (refer to FIG. 3). FIG. 3 illustrates an equivalent circuit of the auxiliary circuit and the second control unit 52 in a situation where the bidirectional switch 8 is ON. As used herein, the situation where the bidirectional switch 8 is ON refers to a situation where at least one of the third switching element 6 or the fourth switching element 7 is in ON state. Each of the first drive circuit 521 and the second drive circuit 522 has a higher-potential output terminal and a lower-potential output terminal. Each of the first drive circuit 521 and the second drive circuit 522 is a driver including, for example, a DC power supply and a complementary metal-oxide semiconductor (CMOS) inverter and having the ability to change the voltage value of the output voltage. The first drive circuit 521 is connected between the control terminal (gate terminal) and second main terminal (emitter terminal) of the third switching element 6. The higher potential output terminal of the first drive circuit 521 is connected to the control terminal of the third switching element 6. The lower potential output terminal of the first drive circuit 521 is connected to the second main terminal of the third switching element 6. The second drive circuit 522 is connected between the control terminal (gate terminal) and the second main terminal (emitter terminal) of the fourth switching element 7. The higher potential output terminal of the second drive circuit 522 is connected to the control terminal of the fourth switching element 7. The lower potential output terminal of the second drive circuit 522 is connected to the second main terminal of the fourth switching element 7.

The power converter 100 includes the limiter 15. The limiter 15 limits the absolute value of a voltage variation rate (hereinafter referred to as "dV/dt") of the voltage V8 applied between the first terminal 81 and second terminal 82 of the bidirectional switch 8 to a threshold value or less. The threshold value may be, but does not have to be, 2 kV/$\mu$s.

In the power converter 100, the limiter 15 includes a first resistor R1 and a second resistor R2. The first resistor R1 is connected between the control terminal of the third switching element 6 and the first drive circuit 521. More specifically, the first resistor R1 is connected between the higher potential output terminal of the first drive circuit 521 and the control terminal of the third switching element 6. The second resistor R2 is connected between the control terminal of the fourth switching element 7 and the second drive circuit 522. More specifically, the second resistor R2 is connected between the higher potential output terminal of the second drive circuit 522 and the control terminal of the fourth switching element 7.

The limiter 15 determines the respective resistance values of the first resistor R1 and the second resistor R2 to make the absolute value of the voltage variation rate when the bidirectional switch 8 turns from OFF to ON equal to or less than the threshold value. The limiter 15 includes the first resistor R1 to reduce the absolute value of dV/dt when the third switching element 6 is turned from OFF to ON. The greater the resistance value of the first resistor R1 is, the more significantly the limiter 15 may reduce the absolute value of dV/dt when the third switching element 6 is turned from OFF to ON. The limiter 15 includes the second resistor R2 to reduce the absolute value of dV/dt when the fourth switching element 7 is turned from OFF to ON. The greater the resistance value of the second resistor R2 is, the more significantly the limiter 15 may reduce the absolute value of dV/dt when the fourth switching element 7 is turned from OFF to ON.

(3) Operation of power converter

In the following description, a current flowing through the resonant inductor L1 will be hereinafter designated by iL1, and a current flowing through the AC load RA1 will be hereinafter designated by i1. Also, in the following description, as for each of these currents iL1 and i1, if the current flows in the direction indicated by a corresponding one of the arrows shown in FIG. 1, then the polarity of the current is supposed to be positive. On the other hand, if the current flows in the direction opposite from the one indicated by the arrow shown in FIG. 1, then the polarity of the current is supposed to be negative.

The power converter 100 includes the protection circuit 17 including the third diode 13 and the fourth diode 14 as described above. Thus, in this power converter 100, when the third switching element 6 of the bidirectional switch 8 turns OFF in a state where the third switching element 6 of the bidirectional switch 8 is ON and the positive current iL1 is flowing through the resonant inductor L1, for example, the current iL1 flowing through the resonant inductor L1 is regenerated to the power converter circuit 11 via the third diode 13 until the current iL1 flowing through the resonant inductor L1 goes zero due to the consumption of energy of the resonant inductor L1. Also, in this power converter 100, when the fourth switching element 7 of the bidirectional switch 8 turns OFF in a state where the fourth switching element 7 of the bidirectional switch 8 is ON and the negative current iL1 is flowing through the resonant inductor L1, for example, a current flows along the path passing through the fourth diode 14, the resonant inductor L1, and the regenerative element 12 in this order until the current iL1 flowing through the resonant inductor L1 goes zero due to the consumption of energy of the resonant inductor L1.

Next, it will be described with reference to FIGS. 1 and 2 how the controller 50 operates when performing zero-voltage soft switching control on the first switching element 1. When performing zero-voltage soft switching control on the second switching element 2, the controller 50 operates in the same way as when performing zero-voltage soft switching control on the first switching element 1, and therefore, description thereof will be omitted herein.

When the zero-voltage soft switching control is performed on the first switching element 1, the voltage across the first switching element 1 needs to be reduced to zero just before the first switching element 1 turns ON. Thus, the controller 50 reduces the voltage across the first switching element 1 to zero by turning the third switching element 6 ON to cause the resonant inductor L1 and the resonant capacitor 9 to produce resonance and thereby charge the resonant capacitor 9 with the electric charges removed from the regenerative element 12.

On the other hand, when the zero-voltage soft switching control is performed on the second switching element 2, the voltage across the second switching element 2 needs to be reduced to zero just before the second switching element 2 turns ON. Thus, the controller 50 reduces the voltage across the second switching element 2 to zero by turning the fourth switching element 7 ON to cause the resonant inductor L1 and the resonant capacitor 9 to produce resonance and thereby remove the electric charges from the resonant capacitor 9 to the regenerative element 12. The controller 50 charges and discharges the resonant capacitor 9 via the bidirectional switch 8 such that the dead time Td agrees with a half cycle ($\pi \times \sqrt{LC}$) of LC resonance. This allows the power converter 100 to make zero-voltage soft switching.

The PWM signals S1, S2 to be respectively supplied from the controller 50 to the first switching element 1 and the second switching element 2 of the switching circuit 10 are shown in FIG. 2. In addition, the control signals S6, S7 to be respectively supplied from the controller 50 to the third switching element 6 and fourth switching element 7 of the bidirectional switch 8 are also shown in FIG. 2. Furthermore, the current i1 flowing through the AC load RA1, the current iL1 flowing through the resonant inductor L1, the voltage V1 across the first switching element 1, and the voltage across the second switching element 2 are also shown in FIG. 2. Furthermore, the voltage V8 between the second terminal 82 and first terminal 81 of the bidirectional switch 8 is also shown in FIG. 2. The voltage V8 is the voltage between the second terminal 82 and first terminal 81 with the potential at the first terminal 81 defined to be a reference potential. In the following description, the direction pointed to by the arrow shown in FIG. 1 is supposed to be positive. That is to say, when the potential at the second terminal 82 of the bidirectional switch 8 is higher than the potential at the first terminal 81 thereof, the voltage value of the voltage V8 will be a positive value.

Furthermore, the dead time Td that the controller 50 sets to prevent the first switching element 1 and the second switching element 2 from turning ON simultaneously is also shown in FIG. 2. Besides, an additional time Ta set by the controller 50 with respect to the control signal S6 for the third switching element 6 of the bidirectional switch 8 is also shown in FIG. 2.

The additional time Ta is an amount of time that the controller 50 provides to make the high-level period of the control signal S6 longer than the dead time Td by setting the beginning t1 of the high-level period of the control signal S6 to be supplied to the third switching element 6 of the bidirectional switch 8 at a point in time earlier than the beginning (point in time t2) of the dead time Td provided to prevent the first switching element 1 and the second switching element 2 from turning ON simultaneously. The length of the additional time Ta is determined by the value of the current i1. To start producing the LC resonance from the beginning (point in time t2) of the dead time Td in the auxiliary circuit, it is preferable that the value of the current iL1 agree with the value of the current i1 at the beginning (point in time t2) of the dead time Td. This is because as long as iL1 < i1 is satisfied, all current flows through the AC load RA1, and therefore, the resonant capacitor 9 cannot be charged. The end of the high-level period of the control signal S6 may be simultaneous with, or later than, the end (point in time t3) of the dead time Td. In the example illustrated in FIG. 2, the end of the high-level period of the control signal S6 is set to be simultaneous with the end (point in time t3) of the dead time Td. The controller 50 sets the high-level period of the control signal S6 at Ta + Td. The voltage V1 across the first switching element 1 goes zero at the end (point in time t3) of the dead time Td. In the example shown in FIG. 2, the current iL1 starts flowing through the resonant inductor L1 at the beginning t1 of the high-level period of the control signal S6 and goes zero at a time t4 when the additional time Ta has passed since the end (point in time t3) of the dead time Td. At this time, the current iL1 satisfies iL1 $\geq$ i1 from the beginning (point in time t2) of the dead time Td, and therefore, the current iL1 in the shaded part of the current waveform shown as the fifth waveform from the top of FIG. 2 flows into the resonant capacitor 9 to produce LC resonance. From the end (point in time t3) of the dead time Td and on, the current iL1 is regenerated to the power converter circuit 11 via the third diode 13.

To start producing the LC resonance at the beginning (point in time t2) of the dead time Td, the controller 50 determines the additional time Ta based on the current i1 such that iL1 = i1 is satisfied at the beginning (point in time t2) of the dead time Td as described above. More specifically, using either the detection result of the current i1 by a current sensor or a signal processing value thereof, or an estimated value of the current i1, the inductance L of the resonant inductor L1 that has been stored in advance, and the detection result of the voltage V12 across the regenerative element 12, for example, the controller 50 determines the additional time Ta by the equation: Tau = i1 $\times$ (L/V12). In this case, as the detection result of the current i1 or the signal processing value thereof, either a detection value at a carrier cycle at which the additional time Ta is added or a detection value at a timing closest to the carrier cycle may be used. Also, in this case, as the estimated value of the current i1, a value of the current i1 estimated at the carrier cycle at which the additional time Ta is added may be used, for example.

The foregoing description is applicable to a situation where the current iL1 flowing through the resonant inductor L1 and the current iL1 flowing through the AC load RA1 are both positive. FIG. 2 also illustrates a situation where the current iL1 flowing through the resonant inductor L1 and the current i1 flowing through the AC load RA1 are both negative. In addition, FIG. 2 also shows the additional time Ta that the controller 50 sets with respect to the control signal S7 for the fourth switching element 7 of the bidirectional switch 8. The additional time Ta is an amount of time that the controller 50 provides to make the high-level period of the control signal S7 longer than the dead time Td by setting the beginning t5 of the high-level period of the control signal S7 to be supplied to the fourth switching element 7 of the bidirectional switch 8 at a point in time earlier than the beginning (point in time t6) of the dead time Td provided to prevent the first switching element 1 and the second switching element 2 from turning ON simultaneously. In the example shown in FIG. 2, the end of the high-level period of the control signal S7 is set to be simultaneous with the end (point in time t7) of the dead time Td. The controller 50 sets the high-level period of the control signal S7 at Ta + Td. The voltage V2 across the second switching element 1 goes zero at the end (point in time t7) of the dead time Td. In the example shown in FIG. 2, the current iL1 starts flowing through the resonant inductor L1 at the beginning t5 of the high-level period of the control signal S7 and goes zero at a time t8 when the additional time Ta has passed since the end (point in time t7) of the dead time Td.

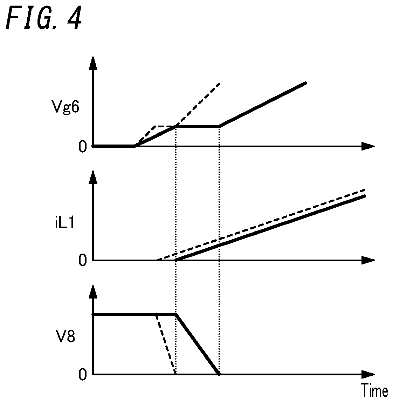

FIG. 4 shows, by the solid lines, the respective waveforms of the gate voltage Vg6 of the third switching element 6, the current iL1 flowing through the resonant inductor L1, and the voltage V8 between the second terminal 82 and first terminal 81 of the bidirectional switch 8 in the power converter 100 for a situation where the current i1 flowing through the AC load RA1 is positive, for example. The gate voltage Vg6 of the third switching element 6 is a gate-emitter voltage of the third switching element 6 and is the voltage between the control terminal and second main terminal of the third switching element 6. FIG. 4 also shows, by the dashed lines, the respective waveforms for a comparative example in which the respective resistance values of the first resistor R1 and the second resistor R2 are set at smaller values than the respective resistance values of the first resistor R1 and second resistor R2 of the power converter 100 according to the first embodiment to make the absolute value of the voltage variation rate when the bidirectional switch 8 turns from OFF to ON greater than the threshold value. As can be seen from FIG. 4, the gate voltage Vg6 rises from 0 V to a plateau voltage less steeply in the power converter 100 according to the first embodiment than in the comparative example, a mirror period in which the gate voltage Vg6 remains a substantially constant plateau voltage is longer in the power converter 100 according to the first embodiment than in the comparative example, and the gate voltage Vg6 rises less steeply from the plateau voltage after the mirror period in the power converter 100 according to the first embodiment than in the comparative example. In addition, as can also be seen from FIG. 4, in the power converter 100 according to the first embodiment, the voltage V8 applied to the bidirectional switch 8 starts to change later than in the comparative example. Furthermore, as can also be seen from FIG. 4, the absolute value of the voltage variation rate of the voltage V8 applied to the bidirectional switch 8 is smaller in the power converter 100 according to the first embodiment than in the comparative example. Furthermore, as can also be seen from FIG. 4, in the power converter 100 according to the first embodiment, the current iL1 starts to flow later than in the comparative example.

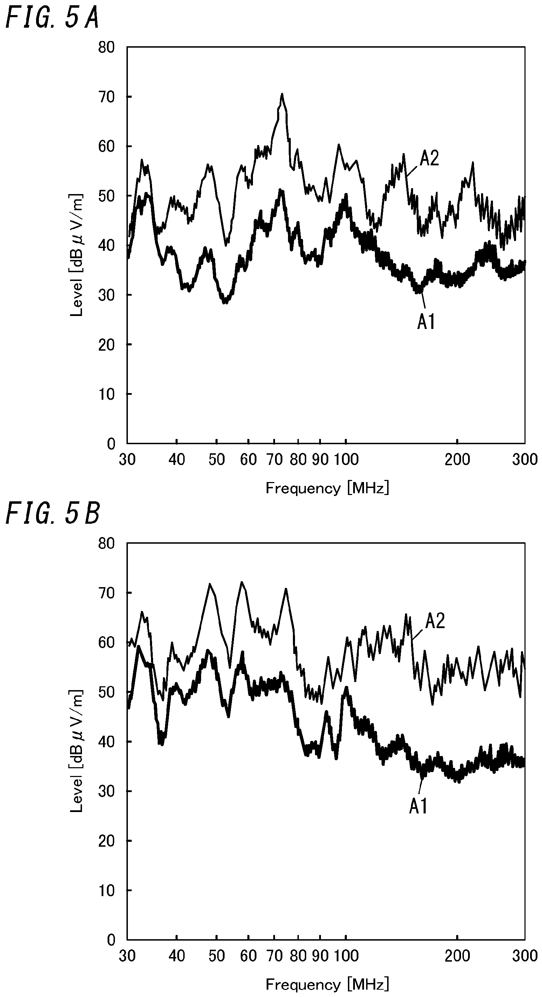

In FIG. 5A, A1 indicates a measured value of the horizontal polarized wave radiation noise produced in the power converter 100 according to the first embodiment. Meanwhile, A2 shown in FIG. 5A indicates a measured value of the horizontal polarized wave radiation noise produced in the power converter according to the comparative example. In FIG. 5B, A1 indicates a measured value of the vertical polarized wave radiation noise produced in the power converter 100 according to the first embodiment. Meanwhile, A2 shown in FIG. 5B indicates a measured value of the vertical polarized wave radiation noise produced in the power converter according to the comparative example. In each of FIGS. 5A and 5B, the abscissa indicates the frequency of the radiation noise, and the ordinate indicates the level of the radiation noise. The radiation noise was measured by the 3 m method under the condition compliant with the CISPR32 standard. In an example of the first embodiment, dV/dt was equal to or less than a threshold value. In the comparative example, dV/dt was greater than the threshold value. As can be seen from FIGS. 5A and 5B, the radiation noise may be reduced by setting dV/dt at a value equal to or less than the threshold value.

(4) Recapitulation

A power converter 100 according to the first embodiment includes a first DC terminal 31 and a second DC terminal 32, a power converter circuit 11, a bidirectional switch 8, a resonant capacitor 9, a resonant inductor L1, a regenerative element 12, a first control unit 51, a second control unit 52, and a limiter 15. The power converter circuit 11 includes: a first switching element 1 and a second switching element 2 which are connected to each other in series; a first diode 4 connected in antiparallel to the first switching element 1; and a second diode 5 connected in antiparallel to the second switching element 2. In the power converter circuit 11, the first switching element 1 is connected to the first DC terminal 31 and the second switching element 2 is connected to the second DC terminal 32. The bidirectional switch 8 has a first terminal 81 and a second terminal 82. In the bidirectional switch 8, the first terminal 81 of the bidirectional switch 8 is connected to a connection node 3 between the first switching element 1 and the second switching element 2. The resonant capacitor 9 is connected between the first terminal 81 of the bidirectional switch 8 and the second DC terminal 32. The resonant inductor L1 is connected to the second terminal 82 of the bidirectional switch 8. The regenerative element 12 is connected between the resonant inductor L1 and the second DC terminal 32. The first control unit 51 controls the first switching element 1 and the second switching element 2. The second control unit 52 controls the bidirectional switch 8. The limiter 15 limits the absolute value of a voltage variation rate (dV/dt) of a voltage V8 applied between the first and second terminals 81, 82 of the bidirectional switch 8 to a threshold value or less.

The power converter 100 according to the first embodiment includes the limiter 15. This allows the power converter 100 to limit the absolute value of the voltage variation rate of the voltage V8 applied to the bidirectional switch 8 to the threshold value or less when making soft switching of each of the first switching element 1 and the second switching element 2. Thus, the power converter 100 according to the first embodiment may reduce the radiation noise to be caused due to a variation in the voltage V8 applied to the bidirectional switch 8 when making soft switching of each of the first switching element 1 and the second switching element 2. Consequently, the power converter 100 according to the first embodiment may reduce the electromagnetic interference (EMI) noise.

In addition, in the power converter 100 according to the first embodiment, the bidirectional switch 8 includes a third switching element 6 and a fourth switching element 7, each of which has a first main terminal, a second main terminal, and a control terminal. The second control unit 52 includes: a first drive circuit 521 connected between the control terminal and the second main terminal of the third switching element 6; and a second drive circuit 522 connected between the control terminal and the second main terminal of the fourth switching element 7. The limiter 15 includes: a first resistor R1 connected between the control terminal of the third switching element 6 and the first drive circuit 521; and a second resistor R2 connected between the control terminal of the fourth switching element 7 and the second drive circuit 522. The limiter 15 determines in advance the resistance value of the first resistor R1 and the resistance value of the second resistor R2 to make the absolute value of the voltage variation rate when the bidirectional switch 8 turns from OFF to ON equal to or less than the threshold value. This allows the power converter 100 according to the first embodiment to limit the gate charging rate of the third switching element 6 and the gate charging rate of the fourth switching element 7 when the third switching element 6 and fourth switching element 7 of the bidirectional switch 8 turn from OFF to ON. Thus, the power converter 100 according to the first embodiment may reduce the absolute value of the voltage variation rate of the voltage V8 applied to the bidirectional switch 8 when the bidirectional switch 8 turns from OFF to ON while making soft switching of the first switching element 1 and the second switching element 2, thus enabling reducing the radiation noise.

(Second embodiment)

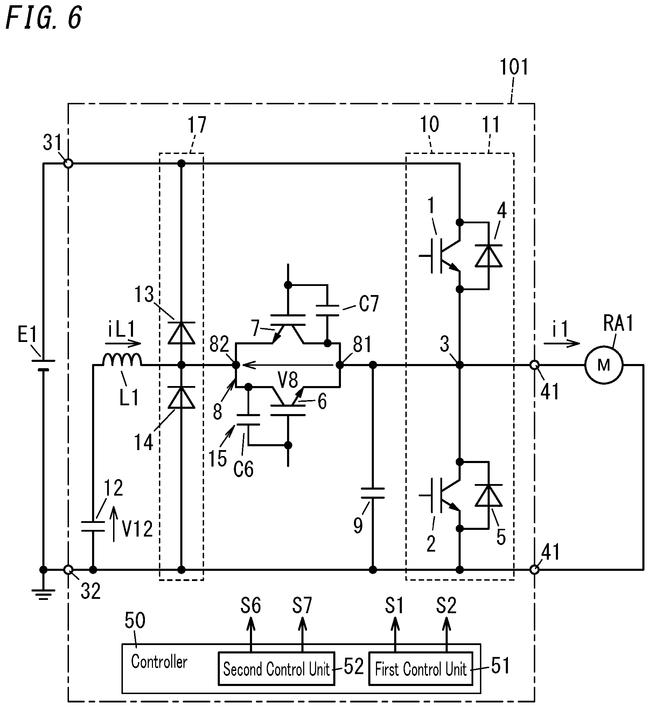

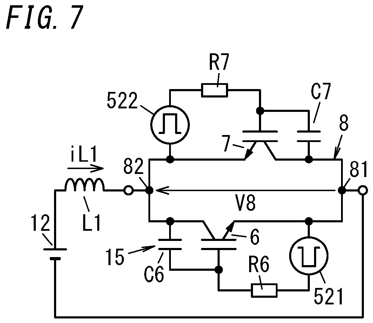

Next, a power converter 101 according to a second embodiment will be described with reference to FIGS. 6 and 7. In the power converter 101 according to the second embodiment, the limiter 15 includes a first capacitor C6 and a second capacitor C7 instead of the first resistor R1 and the second resistor R2, which is a difference from the power converter 100 according to the first embodiment. In the following description, any constituent element of the power converter 101 according to this second embodiment, having the same function as a counterpart of the power converter 100 according to the first embodiment described above, will be designated by the same reference numeral as that counterpart's, and description thereof will be omitted herein.

The first capacitor C6 is connected between the control terminal (gate terminal) and first main terminal (collector terminal) of the third switching element 6. The second capacitor C7 is connected between the control terminal (gate terminal) and first main terminal (collector terminal) of the fourth switching element 7.

The limiter 15 determines the capacitance of the first capacitor C6 and the capacitance of the second capacitor C7 to limit the absolute value of the voltage variation rate when the bidirectional switch 8 turns from OFF to ON to a threshold value or less. The threshold value for the voltage variation rate of the voltage V8 between the second terminal 82 and first terminal 81 of the bidirectional switch 8 may be, but does not have to be, 2 kV/$\mu$s, for example. The capacitance of the first capacitor C6 is greater than the parasitic capacitance between the gate and collector of an IGBT serving as the third switching element 6. Also, the capacitance of the second capacitor C7 is greater than the parasitic capacitance between the gate and collector of an IGBT serving as the fourth switching element 7.

FIG. 7 is an equivalent circuit diagram of an auxiliary circuit and the second control unit 52 in a situation where the bidirectional switch 8 is ON. The power converter 101 includes a first gate resistor R6 connected between the first drive circuit 521 and the control terminal of the third switching element 6 and a second gate resistor R7 connected between the second drive circuit 522 and the control terminal of the fourth switching element 7. The first capacitor C6 is connected to the first gate resistor R6 in series. Thus, the first capacitor C6 is charged via the first gate resistor R6. Also, the second capacitor C7 is connected to the second gate resistor R7 in series. Thus, the second capacitor C7 is charged via the second gate resistor R7.

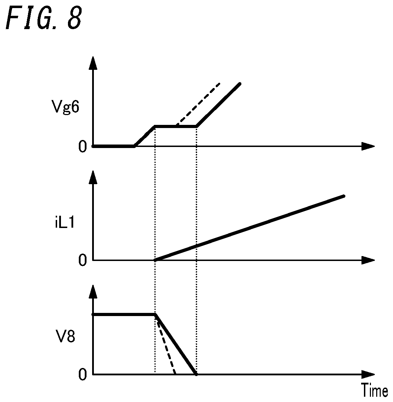

FIG. 8 shows, by the solid lines, the respective waveforms of the gate voltage Vg6 of the third switching element 6, the current iL1 flowing through the resonant inductor L1, and the voltage V8 between the second terminal 82 and first terminal 81 of the bidirectional switch 8 in the power converter 101 for a situation where the current i1 flowing through the AC load RA1 is positive, for example. The gate voltage Vg6 of the third switching element 6 is a gate-emitter voltage of the third switching element 6 and is the voltage between the control terminal and second main terminal of the third switching element 6. FIG. 8 also shows, by the dashed lines, the respective waveforms for a comparative example in which neither the first capacitor C6 nor the second capacitor C7 is provided. As can be seen from FIG. 8, a mirror period in which the gate voltage Vg6 remains a substantially constant plateau voltage is longer in the power converter 101 according to the second embodiment than in the comparative example. In addition, as can also be seen from FIG. 8, the power converter 101 according to the second embodiment may reduce the absolute value of the voltage variation rate of the voltage V8 applied to the bidirectional switch 8.

The power converter 101 according to the second embodiment includes the limiter 15 for limiting the absolute value of the voltage variation rate of the voltage V8 applied between the first terminal 81 and the second terminal 82 of the bidirectional switch 8 to a threshold value or less. Thus, the power converter 101 according to the second embodiment may reduce the radiation noise to be caused when making soft switching of the first switching element 1 and the second switching element 2.

In addition, in the power converter 101 according to the second embodiment, the capacitance of the first capacitor C6 and the capacitance of the second capacitor C7 are determined to make the absolute value of the voltage variation rate when the bidirectional switch 8 turns from OFF to ON equal to or less than the threshold value. This allows the power converter 101 according to the second embodiment to limit the gate charging rate of the third switching element 6 and the gate charging rate of the fourth switching element 7 when the third switching element 6 and fourth switching element 7 of the bidirectional switch 8 turn from OFF to ON. Consequently, the power converter 101 according to the second embodiment may reduce, when making soft switching of the first switching element 1 and the second switching element 2, the absolute value of the voltage variation rate of the voltage V8 applied to the bidirectional switch 8 when the bidirectional switch 8 turns from OFF to ON, and thereby reduce the radiation noise.

(Third embodiment)

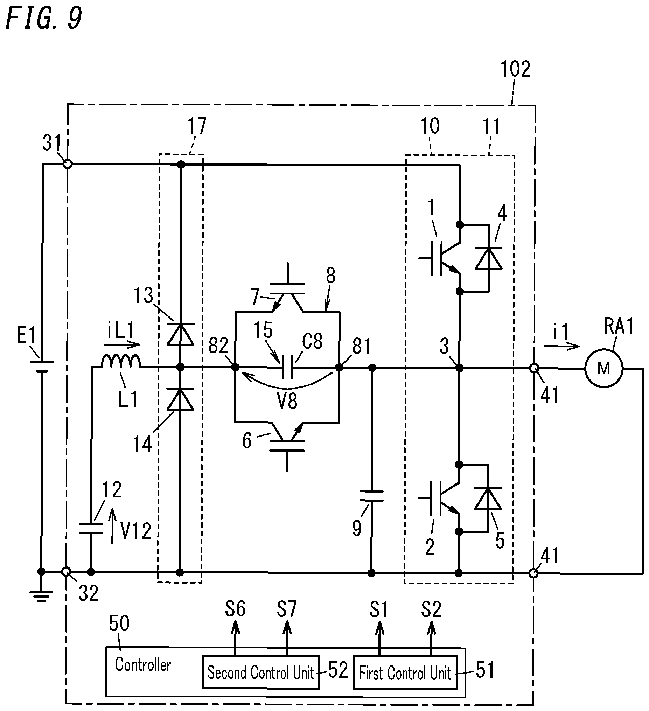

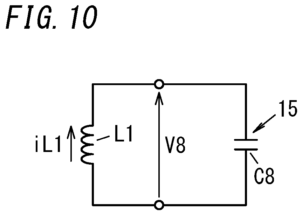

Next, a power converter 102 according to a third embodiment will be described with reference to FIGS. 9 and 10. In the power converter 102 according to the third embodiment, the limiter 15 includes a capacitor C8 instead of the first resistor R1 and the second resistor R2 of the power converter 100 (refer to FIG. 1) according to the first embodiment, which is a difference from the power converter 100 according to the first embodiment. In the following description, any constituent element of the power converter 102 according to this third embodiment, having the same function as a counterpart of the power converter 100 according to the first embodiment described above, will be designated by the same reference numeral as that counterpart's, and description thereof will be omitted herein. Note that the power converter 102 according to the third embodiment, as well as the power converter 101 (refer to FIGS. 6 and 7) according to the second embodiment described above, also includes the first drive circuit 521, the first gate resistor R6, the second drive circuit 522, and the second gate resistor R7.

The capacitor C8 is connected to the bidirectional switch 8 in parallel. That is to say, the capacitor C8 is connected between the first terminal 81 and second terminal 82 of the bidirectional switch 8 and is connected to the third switching element 6 and the fourth switching element 7 in parallel. FIG. 10 is a small signal equivalent circuit diagram of an auxiliary circuit and the limiter 15 when the bidirectional switch 8 is OFF. The limiter 15 determines the capacitance of the capacitor C8 to limit the absolute value of the voltage variation rate when the bidirectional switch 8 turns from ON to OFF to a threshold value or less. The threshold value for the voltage variation rate of the voltage V8 applied between the second terminal 82 and first terminal 81 of the bidirectional switch 8 may be, but does not have to be, 2 kV/$\mu$s, for example. The capacitance of the capacitor C8 is greater than the parasitic capacitance between the first terminal 81 and second terminal 82 of the bidirectional switch 8.

In this power converter 102, if the voltage of the DC power supply E1 connected between the first DC terminal 31 and the second DC terminal 32 is V, the inductance of the resonant inductor L1 is L, the capacitance of the capacitor C8 is C, and dV/dt representing the voltage variation rate of the voltage V8 applied to the bidirectional switch 8 is dV8/dt, then the absolute value of the voltage variation rate when the bidirectional switch 8 turns from ON to OFF is given by the following Equation (1):

$$\left| \frac{dV8}{dt} \right| = \left| \frac{d}{dt} \frac{V}{2} \cos \frac{t}{\sqrt{LC}} \right| \qquad \text{Equation (1)}$$

Thus, the absolute value of the voltage variation rate satisfies:

$$\left|\frac{dV8}{dt}\right| \leq \frac{V}{2\sqrt{LC}}$$

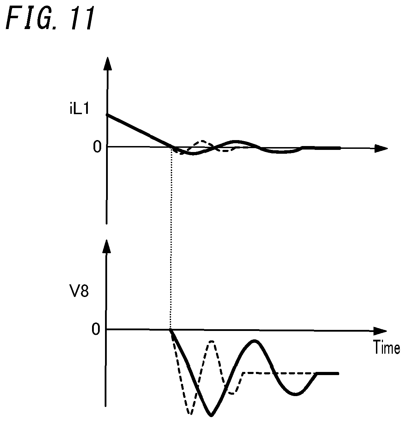

In Equation (1), the inductance of the resonant inductor L1 is determined based on the resonant frequency of soft switching of the first switching element 1 and the second switching element 2. The power converter 102 may lower the ringing frequency of the current iL1 and the voltage V8 and reduce the absolute value of dV8/dt by providing the additional capacitor C8 that is connected to the bidirectional switch 8 in parallel. In FIG. 11, ringing of the current iL1 and the voltage V8 in a comparative example including no capacitor C8 is indicated by the dotted curve and ringing of the current iL1 and the voltage V8 in the power converter 102 according to the third embodiment is indicated by the solid curve. In the comparative example including no capacitor C8, C in Equation (1) represents the parasitic capacitance between the first terminal 81 and second terminal 82 of the bidirectional switch 8.

In the power converter 102 according to the third embodiment described above, the limiter 15 includes the capacitor C8 connected to the bidirectional switch 8 in parallel. The limiter 15 determines the capacitance of the capacitor C8 to limit the absolute value of the voltage variation rate when the bidirectional switch 8 turns from ON to OFF to a threshold value or less. Thus, the power converter 102 according to the third embodiment may reduce the absolute value of the voltage variation rate when the bidirectional switch 8 turns from ON to OFF and thereby reduce the radiation noise.

(Fourth embodiment)

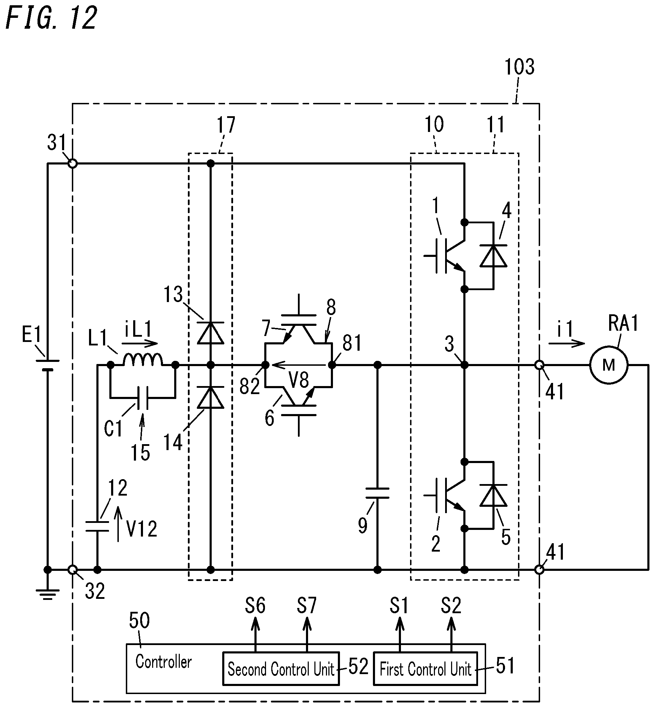

Next, a power converter 103 according to a fourth embodiment will be described with reference to FIG. 12. In the power converter 103 according to the fourth embodiment, the limiter 15 includes a capacitor C1 instead of the first resistor R1 and the second resistor R2 of the power converter 100 (refer to FIG. 1) according to the first embodiment, which is a difference from the power converter 100 according to the first embodiment. In the following description, any constituent element of the power converter 103 according to this fourth embodiment, having the same function as a counterpart of the power converter 100 according to the first embodiment described above, will be designated by the same reference numeral as that counterpart's, and description thereof will be omitted herein. Note that the power converter 103 according to the fourth embodiment, as well as the power converter 101 (refer to FIGS. 6 and 7) according to the second embodiment described above, also includes the first drive circuit 521, the first gate resistor R6, the second drive circuit 522, and the second gate resistor R7.

The capacitor C1 is connected to the resonant inductor L1 in parallel. Thus, the small signal equivalent circuit of the auxiliary circuit and the limiter 15 when the bidirectional switch 8 is OFF has a circuit configuration including the capacitor C1 instead of the capacitor C8 shown in FIG. 10 as described for the third embodiment. The limiter 15 determines the capacitance of the capacitor C1 to limit the absolute value of the voltage variation rate when the bidirectional switch 8 turns from ON to OFF to a threshold value or less. The threshold value for the voltage variation rate of the voltage V8 applied between the second terminal 82 and first terminal 81 of the bidirectional switch 8 may be, but does not have to be, 2 kV/$\mu$s, for example. The capacitance of the capacitor C1 is greater than the parasitic capacitance between the first terminal 81 and second terminal 82 of the bidirectional switch 8.

The power converter 103 may lower the ringing frequency of the current iL1 and the voltage V8 and reduce the absolute value of dV8/dt by providing the additional capacitor C1 that is connected to the resonant inductor L1 in parallel.

In the power converter 103 according to the fourth embodiment described above, the limiter 15 includes the capacitor C1 connected to the resonant inductor L1 in parallel. The limiter 15 determines the capacitance of the capacitor C1 to limit the absolute value of the voltage variation rate when the bidirectional switch 8 turns from ON to OFF to a threshold value or less. Thus, the power converter 103 according to the fourth embodiment may reduce the absolute value of the voltage variation rate when the bidirectional switch 8 turns from ON to OFF and thereby reduce the radiation noise.

(Fifth embodiment)

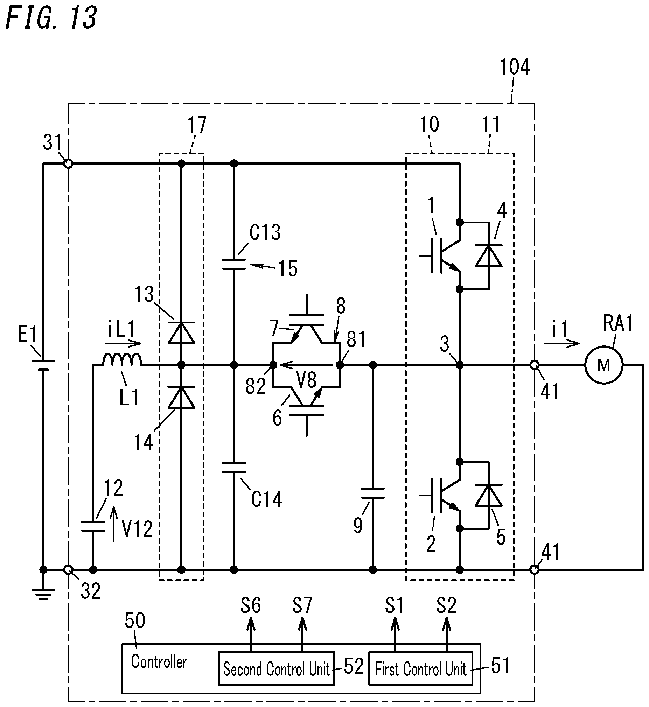

Next, a power converter 104 according to a fifth embodiment will be described with reference to FIG. 13. In the power converter 104 according to the fifth embodiment, the limiter 15 includes a first capacitor C13 and a second capacitor C14 instead of the first resistor R1 and the second resistor R2 of the power converter 100 (refer to FIG. 1) according to the first embodiment, which is a difference from the power converter 100 according to the first embodiment. In the following description, any constituent element of the power converter 104 according to this fifth embodiment, having the same function as a counterpart of the power converter 100 according to the first embodiment described above, will be designated by the same reference numeral as that counterpart's, and description thereof will be omitted herein. Note that the power converter 104 according to the fifth embodiment, as well as the power converter 101 (refer to FIGS. 6 and 7) according to the second embodiment described above, also includes the first drive circuit 521, the first gate resistor R6, the second drive circuit 522, and the second gate resistor R7.

The first capacitor C13 is connected to the third diode 13 in parallel. The second capacitor C14 is connected to the fourth diode 14 in parallel. Thus, the small signal equivalent circuit of the auxiliary circuit and the limiter 15 when the bidirectional switch 8 is OFF has a circuit configuration including a parallel circuit of the first capacitor C13 and the second capacitor C14 instead of the capacitor C8 shown in FIG. 10 as described for the third embodiment. The limiter 15 determines the capacitance of the first capacitor C13 and the capacitance of the second capacitor C14 to limit the absolute value of the voltage variation rate when the bidirectional switch 8 turns from ON to OFF to a threshold value or less. The threshold value for the voltage variation rate of the voltage V8 applied between the second terminal 82 and first terminal 81 of the bidirectional switch 8 may be, but does not have to be, 2 kV/$\mu$s, for example. The capacitance of the first capacitor C13 and the capacitance of the second capacitor C14 are greater than the parasitic capacitance between the first terminal 81 and second terminal 82 of the bidirectional switch 8.

The power converter 104 may lower the ringing frequency of the current iL1 and the voltage V8 and reduce the absolute value of dV8/dt by adding the first capacitor C13 that is connected to the third diode 13 in parallel and the second capacitor C14 that is connected to the fourth diode D14 in parallel.

The power converter 104 according to the fifth embodiment described above includes the third diode 13 and the fourth diode 14. The third diode 13 has its anode connected to the connection node between the bidirectional switch 8 and the resonant inductor L1 and has its cathode connected to the first DC terminal 31. The fourth diode 14 has its anode connected to the connection node between the bidirectional switch 8 and the resonant inductor L1 and has its cathode connected to the second DC terminal 32. The limiter 15 includes the first capacitor C13 connected to the third diode 13 in parallel and the second capacitor C14 connected to the fourth diode 14 in parallel. The limiter 15 determines the capacitance of the first capacitor C13 and the capacitance of the second capacitor C14 to limit the absolute value of the voltage variation rate when the bidirectional switch 8 turns from ON to OFF to a threshold value or less. Thus, the power converter 104 according to the fifth embodiment may reduce the absolute value of the voltage variation rate when the bidirectional switch 8 turns from ON to OFF and thereby reduce the radiation noise.

(Sixth embodiment)

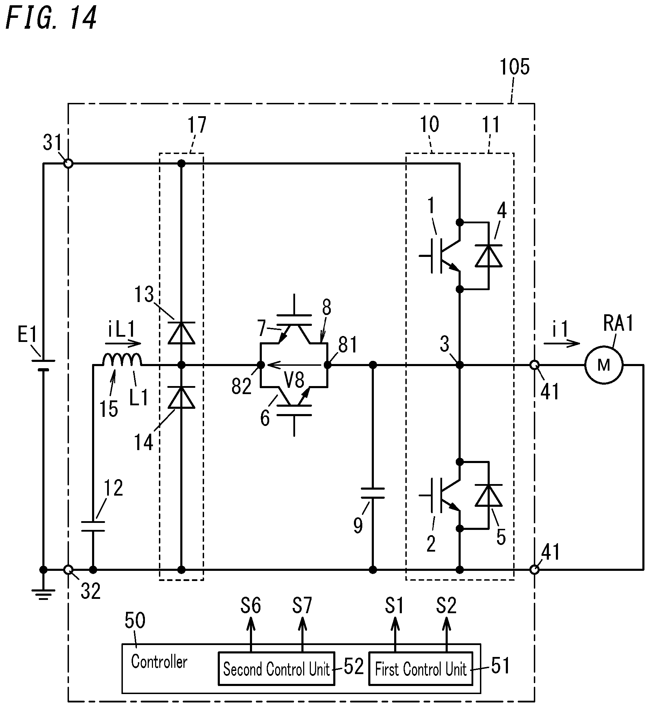

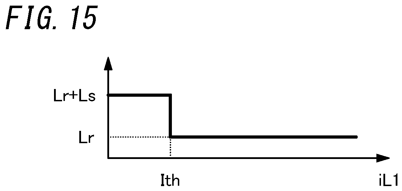

Next, a power converter 105 according to a sixth embodiment will be described with reference to FIGS. 14 and 15. In the power converter 105 according to the sixth embodiment, the resonant inductor L1 has a nonlinear characteristic that makes inductance (Lr + Ls) of the resonant inductor L1 at a value equal to or less than a current threshold value Ith, which is less than a current value of a resonant current, larger than inductance (Lr) of the resonant inductor L1 at the current value of the resonant current, which is a difference from the power converter 100 according to the first embodiment. In the following description, any constituent element of the power converter 105 according to this sixth embodiment, having the same function as a counterpart of the power converter 100 according to the first embodiment described above, will be designated by the same reference numeral as that counterpart's, and description thereof will be omitted herein. Note that the power converter 105 according to the sixth embodiment, as well as the power converter 101 (refer to FIGS. 6 and 7) according to the second embodiment described above, also includes the first drive circuit 521, the first gate resistor R6, the second drive circuit 522, and the second gate resistor R7.

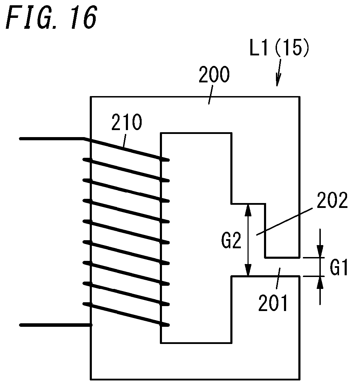

The resonant inductor L1 has a nonlinear characteristic that makes inductance (Lr + Ls) of the resonant inductor L1 when the current iL1 flowing through the resonant inductor L1 has a value equal to or less than the current threshold value Ith, which is less than a current value of a resonant current, larger than inductance (Lr) of the resonant inductor L1 at the current value of the resonant current as shown in FIG. 15, for example. The resonant inductor L1 having such a nonlinear characteristic may include, for example, a C-shaped core 200 and a conductive wire 210 wound around the C-shaped core 200 as shown in FIG. 16. The C-shaped core 200 has a first end surface and a second end surface which face each other. The C-shaped core 200 has, between the first end surface and the second end surface thereof, a gap 201 with a first gap length G1 and a gap 202 with a second gap length G2 greater than the first gap length G1. The resonant inductor L1 does not have to include, as its core, the C-shaped core 200 such as the one shown in FIG. 16 but may also include a combination of an E-shaped core and an I-shaped core as its core.

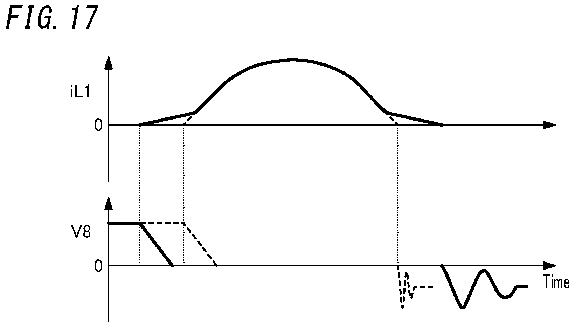

In FIG. 17, the current iL1 and voltage V8 of the power converter 105 according to the sixth embodiment are indicated by the solid curves and the current iL1 and voltage V8 of a comparative example in which the resonant inductor L1 does not have the nonlinear characteristic are indicated by the dashed curves. As shown in FIG. 17, when the bidirectional switch 8 turns from OFF to ON, the voltage V8 starts to decrease earlier in the power converter 105 according to the sixth embodiment than in the comparative example. In addition, as shown in FIG. 17, when the bidirectional switch 8 turns from OFF to ON, the current iL1 starts to flow through the resonant inductor L1 earlier in the power converter 105 according to the sixth embodiment than in the comparative example. In addition, the current iL1 increases from zero less steeply in the power converter 105 according to the sixth embodiment than in the comparative example. Furthermore, as shown in FIG. 17, when the bidirectional switch 8 turns from ON to OFF, the absolute value of the current variation rate of the current iL1 is smaller in the power converter 105 according to the sixth embodiment than in the comparative example. In addition, the current iL1 goes zero later in the power converter 105 according to the sixth embodiment than in the comparative example.

Furthermore, as shown in FIG. 17, the voltage V8 starts ringing later in the power converter 105 according to the sixth embodiment than in the comparative example. In addition, the ringing frequency of the voltage V8 and the absolute value of the voltage variation rate decrease in the power converter 105 according to the sixth embodiment, compared to the comparative example.

In the power converter 105 according to the sixth embodiment, the resonant inductor L1 having the nonlinear characteristic described above also serves as the limiter 15. This allows the power converter 105 according to the sixth embodiment to cut down the switching loss involved when the bidirectional switch 8 turns from OFF to ON without changing the resonant frequency when making soft switching of the first switching element 1 and the second switching element 2. Furthermore, in the power converter 105 according to the sixth embodiment, the resonant inductor L1 also serves as the limiter 15. Thus, the power converter 105 according to the sixth embodiment may reduce the absolute value of the voltage variation rate when the bidirectional switch 8 turns from ON to OFF and thereby reduce the radiation noise.

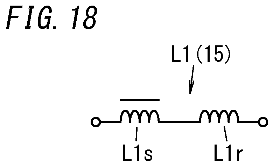

Note that the resonant inductor L1 also serving as the limiter 15 does not have to have the configuration shown in FIG. 16 but may also be formed by, for example, connecting, in series, an inductor L1s which is saturated at the current threshold value Ith (refer to FIG. 17) and an inductor L1r which is not saturated at the current threshold value Ith as shown in FIG. 18. In that case, in the resonant inductor L1, the inductance of the resonant inductor L1s may be Ls and the inductance of the inductor L1r may be Lr, for example. Then, in the resonant inductor L1, the inductor L1r is implemented as an air core coil and the inductor L1s is implemented as a cored coil.

(Seventh embodiment)

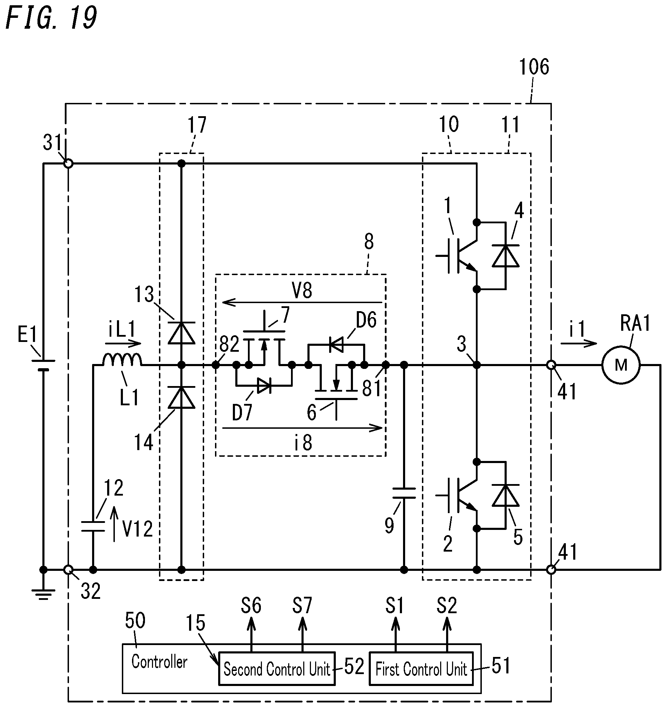

Next, a power converter 106 according to a seventh embodiment will be described with reference to FIG. 19. In the power converter 106 according to the seventh embodiment, the third switching element 6 and the fourth switching element 7 of the bidirectional switch 8 are unipolar transistors, each of which includes a first main terminal (drain terminal), a second main terminal (source terminal), and a control terminal (gate terminal) and which are connected to each other in anti-series, which is a difference from the power converter 100 (refer to FIG. 1) according to the first embodiment. In the following description, any constituent element of the power converter 106 according to this seventh embodiment, having the same function as a counterpart of the power converter 100 according to the first embodiment described above, will be designated by the same reference numeral as that counterpart's, and description thereof will be omitted herein.

In the bidirectional switch 8 of the power converter 106, the unipolar transistor serving as each of the third switching element 6 and the fourth switching element 7 is a normally OFF metal-oxide semiconductor field effect transistor (MOSFET).

In the bidirectional switch 8 of this power converter 106, the first main terminal (drain terminal) of the third switching element 6 and the first main terminal (drain terminal) of the fourth switching element 7 are connected to each other. That is to say, the bidirectional switch 8 is a drain-common bidirectional switch. In the bidirectional switch 8 of the power converter 106, the first terminal 81 of the bidirectional switch 8 is connected to the second main terminal (source terminal) of the third switching element 6 and the second terminal 82 of the bidirectional switch 8 is connected to the second main terminal (source terminal) of the fourth switching element 7. In FIG. 19, a diode D6 connected in antiparallel to the third switching element 6 may be, for example, a body diode (parasitic diode) of the MOSFET serving as the third switching element 6. Also, a diode D7 connected in antiparallel to the fourth switching element 7 may be, for example, a body diode (parasitic diode) of the MOSFET serving as the fourth switching element 7.

In the power converter 106, the second control unit 52 turns ON and OFF the third switching element 6 and the fourth switching element 7 simultaneously. In other words, the second control unit 52 generates the control signal S6 for the third switching element 6 and the control signal S7 for the fourth switching element 7 to make the respective ON periods of the third switching element 6 and the fourth switching element 7 coincide with each other and to make the respective OFF periods of the third switching element 6 and the fourth switching element 7 coincide with each other. Thus, the power converter 106 may reduce the chances of the bidirectional switch 8 operating in an operation mode (diode mode) in which the current path passes through either the diode D6 or the diode D7.

In addition, in the power converter 106, the second control unit 52 is configured to turn OFF the third switching element 6 and the fourth switching element 7 at a timing when the current iL1 flowing through the resonant inductor L1 goes zero. In other words, the second control unit 52 outputs the control signal S6 and the control signal S7 which have been generated to turn OFF the third switching element 6 and the fourth switching element 7 at the timing when the current iL1 flowing through the resonant inductor L1 goes zero. In the power converter 106, the second control unit 52 also serves as the limiter 15.

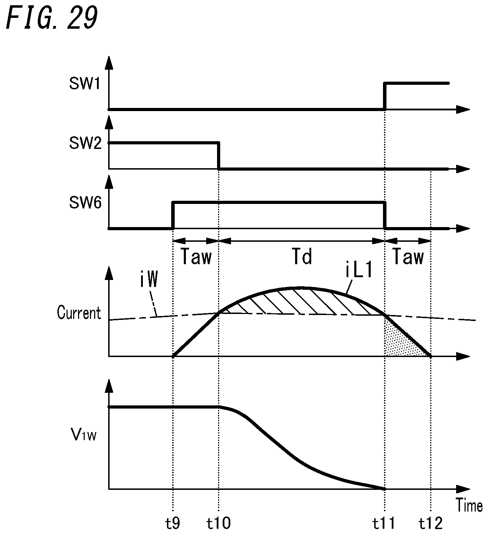

FIG. 29 shows, in a situation where the current i1 flowing from the power converter 106 toward the AC load RA1 is positive, the respective waveforms of the PWM signal S1, the control signal S6, the control signal S7, the current iL1, the voltage V8, and a current i8, of which the polarity is positive when the current i8 flows from the second terminal 82 of the bidirectional switch 8 toward the first terminal 81 thereof.

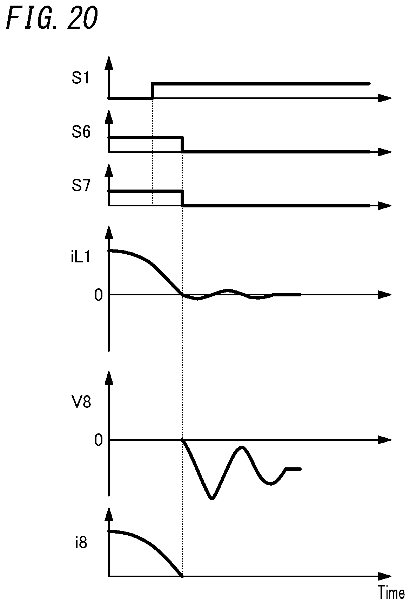

In this power converter 106, after the current iL1 has gone zero, free vibration is produced by the inductor L1 and the parasitic capacitance of the parasitic capacitor/clamp diode (i.e., either the third diode 13 or the fourth diode 14) between the first terminal 81 and second terminal 82 of the bidirectional switch 8 as shown in FIG. 20. At this time, the voltage variation rate is determined by the inductance L of the resonant inductor L1 and the capacitance value of the parasitic capacitor as in Equation (1).

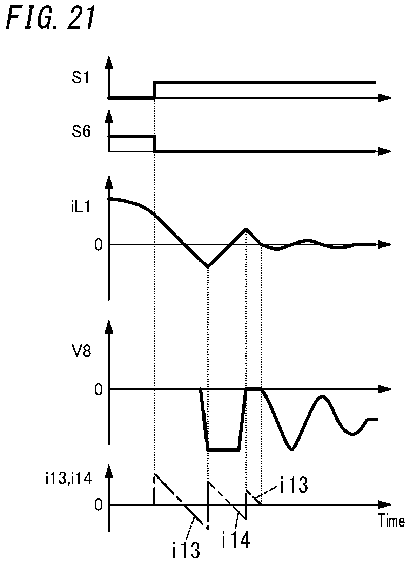

FIG. 21 shows, as for a comparative example in which the second control unit 52 turns OFF the bidirectional switch 8 before the current iL1 goes zero, the respective waveforms of the PWM signal S1, the control signal S6, the current iL1, the voltage V8, a reverse recovery current i13 flowing through the third diode 13, and a reverse recovery current i14 flowing through the diode 14. The reverse recovery current i13 is a current, of which the polarity is positive when the current flows from the anode of the third diode 13 toward the cathode thereof. The reverse recovery current i 14 is a current, of which the polarity is positive when the current flows from the anode of the fourth diode 14 toward the cathode thereof.

As can be seen from FIG. 21, in the comparative example, once the current flowing through the resonant inductor L1 has gone zero, a first operation that the reverse recovery current of the clamp diode causes the current to continue to flow through the resonant inductor L1 and a second operation that a recirculation route switches due to the end of the reverse recovery of one clamp diode will be repeated until the effect of the reverse recovery disappears and then the same free vibration as the one shown in FIG. 20 starts to be produced. Thus, in the comparative example, even after the current iL1 flowing through the resonant inductor L1 has gone zero, it takes a longer time for the current iL1 to vibrate to be maintained at zero due to the effect of the reverse recovery current i13 and the reverse recovery current i14, for example. In addition, as can also be seen from FIG. 21, in the comparative example, when the diode that serves as the clamp diode switches between the third diode 13 and the fourth diode 14, the voltage variation rate increases. In particular, in the comparative example, the voltage variation rate of the voltage V8 involved with the switch of the recirculation route at the time of the second operation is higher than the voltage variation rate produced by the free vibration, and therefore, the absolute value of the voltage variation rate poses a problem.

As can be seen from FIGS. 20 and 21, in the power converter 106 according to the seventh embodiment, the absolute value of the voltage variation rate of the voltage V8 applied to the bidirectional switch 8 decreases compared to the comparative example. The power converter 106 according to this embodiment is made to operate to prevent any current from flowing through the diode to be affected by the reverse recovery, thereby realizing the operation shown in FIG. 20 and reducing the absolute value of the voltage variation rate of the voltage V8 applied to the bidirectional switch 8.

In the power converter 106 according to the seventh embodiment described above, the bidirectional switch 8 includes the third switching element 6 and the fourth switching element 7, each of which includes the first main terminal, the second main terminal, and the control terminal and which are connected to each other in anti-series. Each of the third switching element 6 and the fourth switching element 7 is a unipolar transistor. The second control unit 52 is configured to turn OFF the third switching element 6 and the fourth switching element 7 at the timing when the current iL1 flowing through the resonant inductor L1 goes zero. In the power converter 106, the second control unit 52 also serves as the limiter 15.

The power converter 106 according to the seventh embodiment may reduce the absolute value of the voltage variation rate when the bidirectional switch 8 turns from ON to OFF and thereby reduce the radiation noise.

(Eighth embodiment)

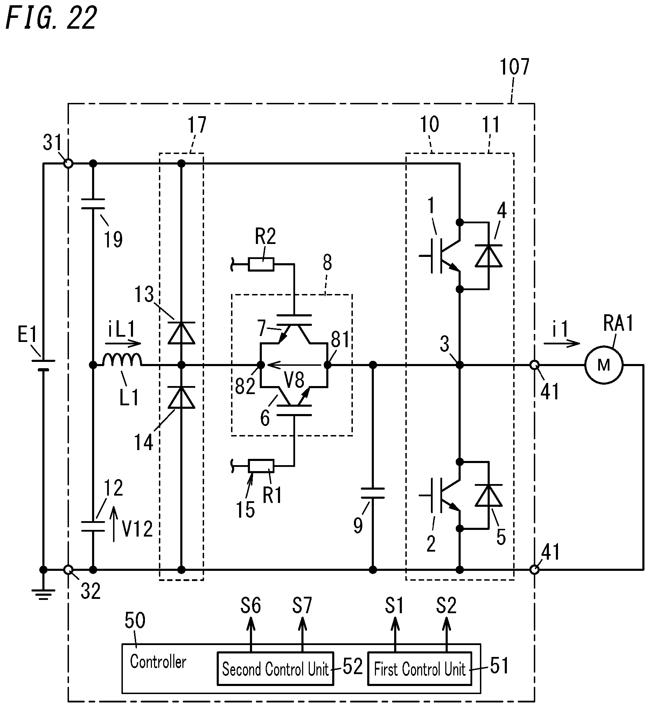

Next, a power converter 107 according to an eighth embodiment will be described with reference to FIG. 22. The power converter 107 according to the eighth embodiment further includes a capacitor 19 connected between the second terminal of the resonant inductor L1 and the first DC terminal 31, which is a difference from the power converter 100 (refer to FIG. 1) according to the first embodiment described above. In the following description, any constituent element of the power converter 107 according to this eighth embodiment, having the same function as a counterpart of the power converter 100 according to the first embodiment described above, will be designated by the same reference numeral as that counterpart's, and description thereof will be omitted herein.

The capacitor 19 is connected to the regenerative element 12 in series. Thus, in this power converter 107, a series circuit of the capacitor 19 and the regenerative element 12 is connected between the first DC terminal 31 and the second DC terminal 32. The capacitance of the capacitor 19 is the same as the capacitance of the capacitor serving as the regenerative element 12. As used herein, the expression "the capacitance of the capacitor 19 is the same as the capacitance of the capacitor serving as the regenerative element 12" refers to not only a situation where the capacitance of the capacitor 19 is exactly the same as the capacitance of the capacitor serving as the regenerative element 12 but also a situation where the capacitance of the capacitor 19 falls within the range from 95% to 105% of the capacitance of the capacitance serving as the regenerative element 12.

In the power converter 107 according to the eighth embodiment, the voltage V1 across the regenerative element 12 has a value calculated by dividing the output voltage of the DC power supply E1 by the capacitor 19 and the regenerative element 12. Thus, the voltage V12 across the regenerative element 12 comes to have a value which is approximately one half of the output voltage of the DC power supply E1. In the power converter 107 according to the eighth embodiment, the controller 50 may store, in advance, the value of the voltage V12 across the regenerative element 12.

The power converter 107 according to the eighth embodiment, as well as the power converter 100 according to the first embodiment, also includes the limiter 15. This allows, when making soft switching of each of the first switching element 1 and the second switching element 2, the absolute value of the voltage variation rate of the voltage V8 applied to the bidirectional switch 8 to be limited to a threshold value or less. Thus, the power converter 107 according to the eighth embodiment may reduce, when making soft switching of each of the first switching element 1 and the second switching element 2, the radiation noise to be caused due to a variation in the voltage V8 applied to the bidirectional switch 8.

(Ninth embodiment)

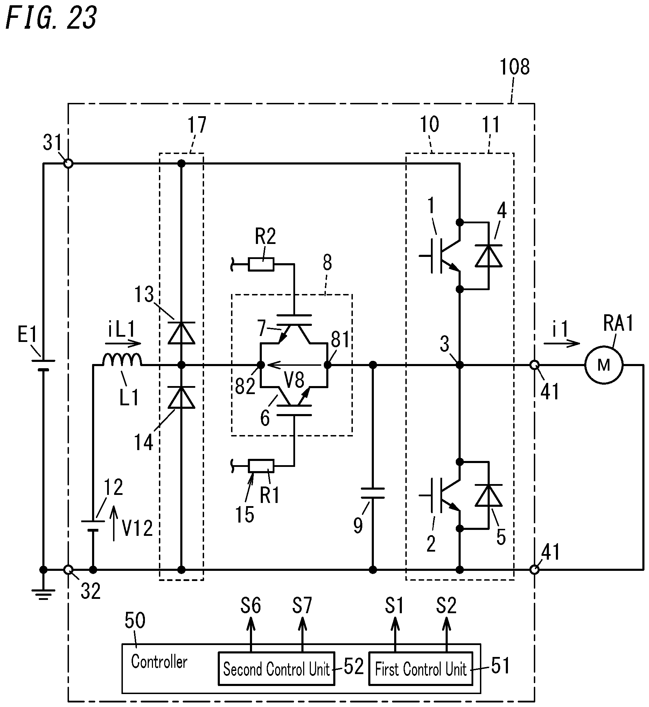

Next, a power converter 108 according to a ninth embodiment will be described with reference to FIG. 23. In the power converter 108 according to the ninth embodiment, the regenerative element 12 is a constant voltage source, which is a difference from the power converter 100 (refer to FIG. 1) according to the first embodiment described above. In the following description, any constituent element of the power converter 108 according to this ninth embodiment, having the same function as a counterpart of the power converter 100 according to the first embodiment described above, will be designated by the same reference numeral as that counterpart's, and description thereof will be omitted herein.

In the power converter 108 according to the ninth embodiment, the regenerative element 12 is a constant voltage source, and therefore, the controller 50 may store, in advance, the value of the voltage V12 across the regenerative element 12.

The power converter 108 according to the ninth embodiment, as well as the power converter 100 according to the first embodiment, also includes the limiter 15. This allows, when making soft switching of each of the first switching element 1 and the second switching element 2, the absolute value of the voltage variation rate of the voltage V8 applied to the bidirectional switch 8 to be limited to a threshold value or less. Thus, the power converter 108 according to the ninth embodiment may reduce, when making soft switching of each of the first switching element 1 and the second switching element 2, the radiation noise to be caused due to a variation in the voltage V8 applied to the bidirectional switch 8.

(Tenth embodiment)

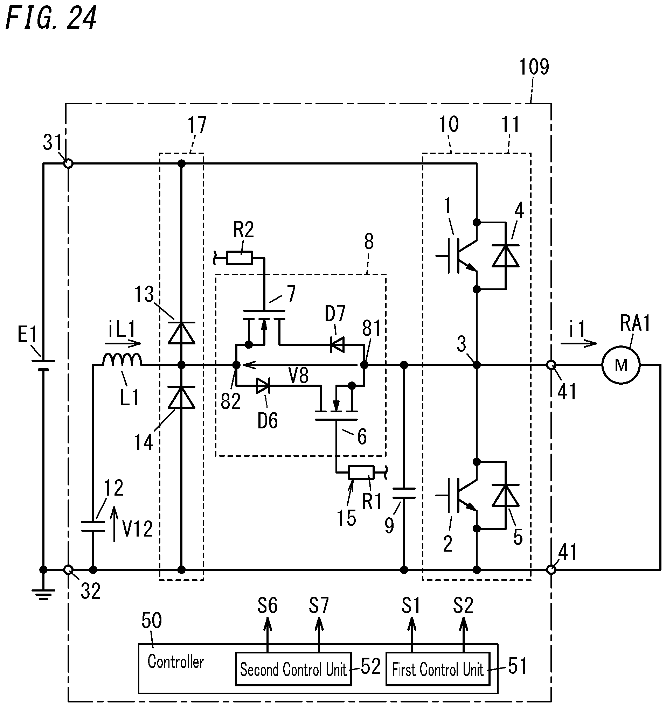

Next, a power converter 109 according to a tenth embodiment will be described with reference to FIG. 24. In the power converter 109 according to the tenth embodiment, the third switching element 6 and the fourth switching element 7 in the bidirectional switch 8 are unipolar transistors, each of which includes a first main terminal (drain terminal), a second main terminal (source terminal), and a control terminal (gate terminal) and which are connected in antiparallel to each other, which is a difference from the power converter 100 (refer to FIG. 1) according to the first embodiment described above. In the following description, any constituent element of the power converter 109 according to this tenth embodiment, having the same function as a counterpart of the power converter 100 according to the first embodiment described above, will be designated by the same reference numeral as that counterpart's, and description thereof will be omitted herein.

In the bidirectional switch 8 of the power converter 109, the unipolar transistor serving as each of the third switching element 6 and the fourth switching element 7 is a normally OFF MOSFET.

In the bidirectional switch 8 of the power converter 109, the first main terminal (drain terminal) of the third switching element 6 and the second main terminal (source terminal) of the fourth switching element 7 are connected to each other, and the second main terminal (source terminal) of the third switching element 6 and the first main terminal (drain terminal) of the fourth switching element 7 are connected to each other. In this embodiment, the bidirectional switch 8 further includes a diode D6 connected to the third switching element 6 in series and a diode D7 connected to the fourth switching element 7 in series. In the bidirectional switch 8, the first main terminal of the third switching element 6 is connected to the second main terminal of the fourth switching element 7 via the diode D6, and the first main terminal of the fourth switching element 7 is connected to the second main terminal of the third switching element 6 via the diode D7. The first terminal 81 of the bidirectional switch 8 is a connection node between the second main terminal of the third switching element 6 and the anode of the diode D7. Also, the second terminal 82 of the bidirectional switch 8 is a connection node between the second main terminal of the fourth switching element 7 and the anode of the diode D6.

The power converter 109 according to the tenth embodiment, as well as the power converter 100 according to the first embodiment, also includes the limiter 15. This allows, when making soft switching of each of the first switching element 1 and the second switching element 2, the absolute value of the voltage variation rate of the voltage V8 applied to the bidirectional switch 8 to be limited to a threshold value or less. Thus, the power converter 109 according to the tenth embodiment may reduce, when making soft switching of each of the first switching element 1 and the second switching element 2, the radiation noise to be caused due to a variation in the voltage V8 applied to the bidirectional switch 8.

(Eleventh embodiment)

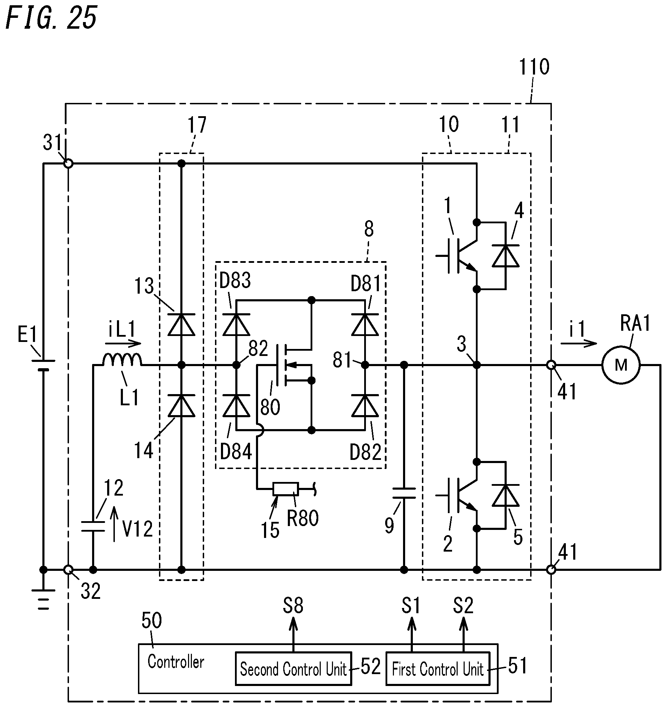

Next, a power converter 110 according to an eleventh embodiment will be described with reference to FIG. 25. In the power converter 110 according to the eleventh embodiment, the bidirectional switch 8 has a different configuration from the bidirectional switch 8 of the power converter 100 (refer to FIG. 1) according to the first embodiment. In the following description, any constituent element of the power converter 110 according to this eleventh embodiment, having the same function as a counterpart of the power converter 100 according to the first embodiment described above, will be designated by the same reference numeral as that counterpart's, and description thereof will be omitted herein.

In the power converter 110, the bidirectional switch 8 includes a single normally OFF MOSFET 80, a series circuit of two diodes D81, D82 connected in antiparallel to the MOSFET 80, and a series circuit of two diodes D83, D84 connected in antiparallel to the MOSFET 80. In the bidirectional switch 8, a connection node between the diodes D81, D82 of the bidirectional switch 8 (i.e., the first terminal 81 of the bidirectional switch 8) is connected to the connection node 3 of the switching circuit 10 and a connection node between the diodes D83, D84 (i.e., the second terminal 82 of the bidirectional switch 8) is connected to the first terminal of the resonant inductor L1. In the bidirectional switch 8, when the MOSFET 80 is ON, the bidirectional switch 8 is ON. On the other hand, when the MOSFET 80 is OFF, the bidirectional switch 8 is OFF.

The MOSFET 80 of the bidirectional switch 8 is controlled by the second control unit 52. The second control unit 52 outputs a control signal S8 to control the ON/OFF states of the MOSFET 80 of the bidirectional switch 8.

In the bidirectional switch 8, when the MOSFET 80 is ON, a resonant current produced by a resonant circuit including the resonant inductor L1 and the resonant capacitor 9 flows. In this power converter 110, when the bidirectional switch 8 is ON, a charging current including the resonant current flows along the path passing through the regenerative element 12, the resonant inductor L1, the diode D83, the MOSFET 80, the diode D82, and the resonant capacitor 9 in this order. Also, in this power converter 110, when the bidirectional switch 8 is ON, a discharging current including the resonant current flows along the path passing through the resonant capacitor 9, the diode D81, the MOSFET 80, the diode D84, the resonant inductor L1, and the regenerative element 12 in this order.

The power converter 110 according to the eleventh embodiment, as well as the power converter 100 according to the first embodiment, also includes the limiter 15 which limits the absolute value of the voltage variation rate of the voltage V8 (refer to FIG. 1) applied between the first terminal 81 and second terminal 82 of the bidirectional switch 8 to a threshold value or less.

In this power converter 110, the limiter 15 includes a resistor R80 connected between the control terminal (gate terminal) of the MOSFET 80 and the drive circuit of the second control unit 52. More specifically, the resistor R80 is connected between the higher-potential output terminal of the drive circuit and the control terminal of the MOSFET 80.

The limiter 15 includes the resistor R80 to reduce the absolute value of the voltage variation rate of the voltage V8 when the bidirectional switch 8 turns from OFF to ON. The limiter 15 determines the resistance value of the resistor R80 to limit the absolute value of the voltage variation rate when the bidirectional switch 8 turns from OFF to ON to the threshold value or less. The greater the resistance value of the resistor R80 is, the more significantly the limiter 15 may reduce the absolute value of the voltage variation rate of the voltage V8 when the bidirectional switch 8 turns from OFF to ON.

The power converter 110 according to the eleventh embodiment, as well as the power converter 100 according to the first embodiment, also includes the limiter 15. This allows, when making soft switching of each of the first switching element 1 and the second switching element 2, the absolute value of the voltage variation rate of the voltage V8 applied between the first terminal 81 and the second terminal 82 of the bidirectional switch 8 to be limited to a threshold value or less. Thus, the power converter 110 according to the eleventh embodiment may reduce, when making soft switching of each of the first switching element 1 and the second switching element 2, the radiation noise to be caused due to a variation in the voltage V8 applied to the bidirectional switch 8.

(Twelfth embodiment)

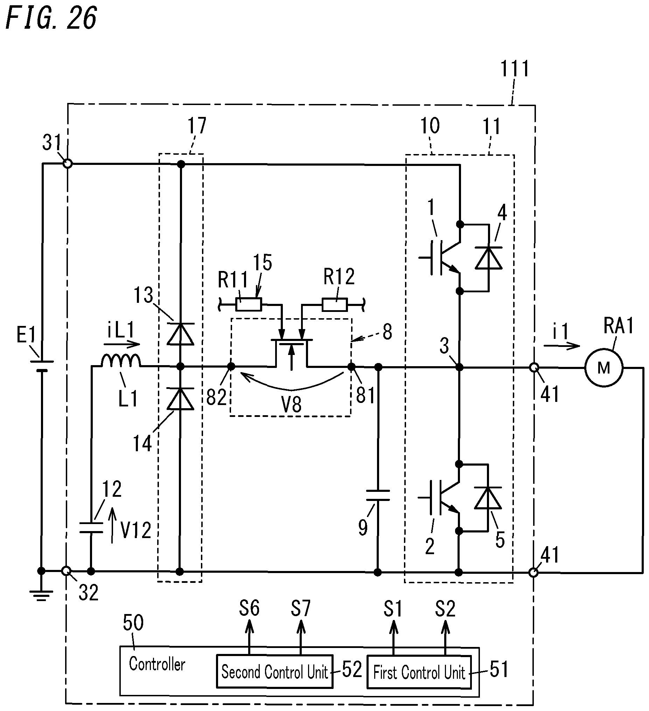

Next, a power converter 111 according to a twelfth embodiment will be described with reference to FIG. 26. In the power converter 111 according to the twelfth embodiment, the bidirectional switch 8 has a different configuration from the bidirectional switch 8 of the power converter 100 (refer to FIG. 1) according to the first embodiment. In the following description, any constituent element of the power converter 111 according to this twelfth embodiment, having the same function as a counterpart of the power converter 100 according to the first embodiment described above, will be designated by the same reference numeral as that counterpart's, and description thereof will be omitted herein.

In the power converter 111, the bidirectional switch 8 is a dual-gate bidirectional device and includes a first gate terminal, a second gate terminal, a first main terminal (first source terminal), and a second main terminal (second source terminal). The bidirectional switch 8 may be, for example, a dual-gate GaN-based gate injection transistor (GIT) and includes a first gate terminal, a first source terminal associated with the first gate terminal, a second gate terminal, and a second source terminal associated with the second gate terminal. In this embodiment, the first terminal 81 of the bidirectional switch 8 is implemented as the first source terminal and the second terminal 82 of the bidirectional switch 8 is implemented as the second source terminal.

The bidirectional switch 8 is controlled by the second control unit 52. In this power converter 111, the second control unit 52 applies the control signal S6 between the first gate terminal and the first source terminal and applies the control signal S6 between the second gate terminal and the second source terminal.

The power converter 111, as well as the power converter 100 according to the first embodiment, also includes the limiter 15 which limits the absolute value of the voltage variation rate of the voltage V8 applied between the first terminal 81 and second terminal 82 of the bidirectional switch 8 to a threshold value or less.

In this power converter 111, the limiter 15 includes a first resistor R11 connected between the first gate terminal and the first drive circuit of the second control unit 52 and a second resistor R12 connected between the second gate terminal and the second drive circuit of the second control unit 52. More specifically, the first resistor R11 is connected between the higher-potential output terminal of the first drive circuit and the first gate terminal of the bidirectional switch 8. The second resistor R12 is connected between the higher-potential output terminal of the second drive circuit and the second gate terminal of the bidirectional switch 8.

The limiter 15 determines the respective resistance values of the first resistor R11 and the second resistor R12 to make the absolute value of the voltage variation rate when the bidirectional switch 8 turns from OFF to ON equal to or less than the threshold value. The larger the resistance values of the first resistor R11 and the second resistor R12 are, the more significantly the limiter 15 may reduce the absolute value of the voltage variation rate of the voltage V8 when the bidirectional switch 8 turns from OFF to ON.

The power converter 111 according to the twelfth embodiment, as well as the power converter 100 according to the first embodiment, also includes the limiter 15. This allows, when making soft switching of each of the first switching element 1 and the second switching element 2, the absolute value of the voltage variation rate of the voltage V8 applied between the first terminal 81 and the second terminal 82 of the bidirectional switch 8 to be limited to a threshold value or less. Thus, the power converter 111 according to the twelfth embodiment may reduce, when making soft switching of each of the first switching element 1 and the second switching element 2, the radiation noise to be caused due to a variation in the voltage V8 applied to the bidirectional switch 8.

(Thirteenth embodiment)

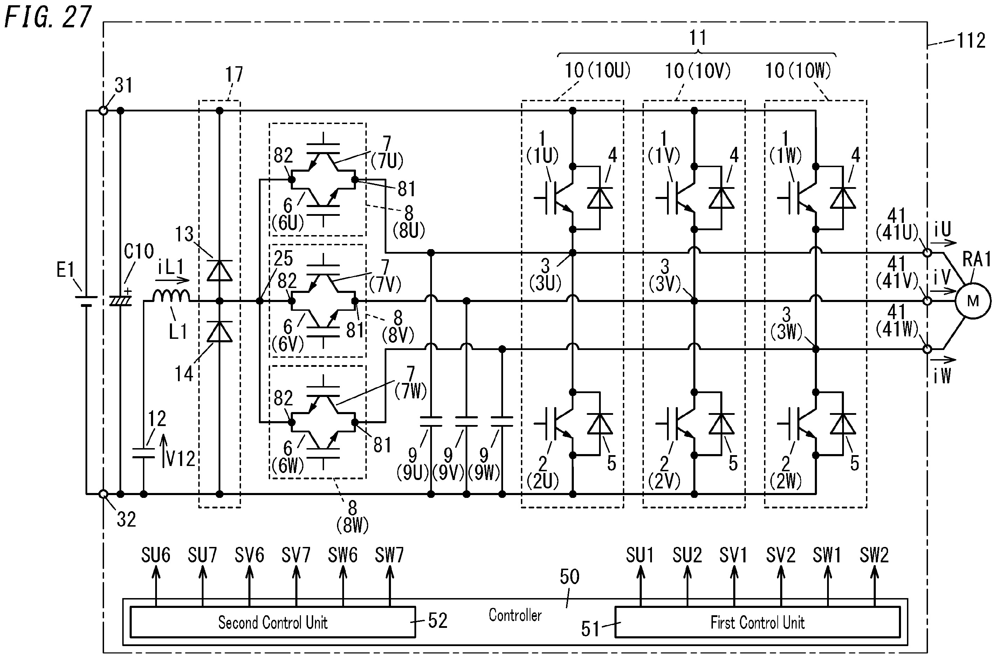

Next, a power converter 112 according to a thirteenth embodiment will be described with reference to FIGS. 27-30. In the following description, any constituent element of the power converter 112 according to this thirteenth embodiment, having the same function as a counterpart of the power converter 100 (refer to FIG. 1) according to the first embodiment described above, will be designated by the same reference numeral as that counterpart's, and description thereof will be omitted herein.

The power converter 112 includes a first DC terminal 31 and a second DC terminal 32, and a plurality of (e.g., three) AC terminals 41 as shown in FIG. 27, for example. A DC power supply E1 is connected between the first DC terminal 31 and the second DC terminal 32. An AC load RA1 is connected to the plurality of AC terminals 41. The AC load RA1 may be, for example, a three-phase motor. The power converter 112 converts the DC output of the DC power supply E1 into AC power and outputs the AC power to the AC load RA1. The DC power supply E1 may include, for example, a solar cell or a fuel cell. The DC power supply E1 may include a DC-DC converter. In the power converter 112, if the DC power supply E1 connected between the first DC terminal 31 and the second DC terminal 32 is a storage battery, for example, the plurality of AC terminals 41 may be connected to a power grid, instead of the AC load RA1. This allows the power converter 112 to convert the DC power supplied from the DC power supply E1 into AC power and output the AC power to the power grid. This also allows the power converter 112 to convert the AC power supplied from the power grid into DC power and output the DC power to the DC power supply E1. As used herein, the "power grid" refers to the overall system to be used by an electricity provider such as an electric power utility company to supply electric power to a customer's power receiving equipment. In the power converter 112, if the plurality of AC terminals 41 are three AC terminals 41, then the AC power may be, for example, three-phase AC power having U-, V-, and W-phases.

The power converter 112 includes a power converter circuit 11, a plurality of (e.g., three) bidirectional switches 8, a plurality of (e.g., three) resonant capacitors 9, a resonant inductor L1, a regenerative element 12, and a controller 50. The power converter circuit 11 includes a plurality of (e.g., three) first switching elements 1 and a plurality of (e.g., three) second switching elements 2. In the power converter circuit 11, a plurality of (e.g., three) switching circuits 10, in each of which one of the plurality of first switching elements 1 and a corresponding one of the plurality of second switching elements 2 are connected one to one in series, are connected in parallel. In the power converter circuit 11, the plurality of first switching elements 1 are connected to the first DC terminal 31 and the plurality of second switching elements 2 are connected to the second DC terminal 32. The plurality of AC terminals 41 are provided one to one for the plurality of switching circuits 10, respectively. Each of the plurality of AC terminals 41 is connected to a connection node 3 between the first switching element 1 and the second switching element 2 of a corresponding one of the plurality of switching circuits 10. The plurality of bidirectional switches 8 are provided one to one for the plurality of switching circuits 10, respectively. Each of the plurality of bidirectional switches 8 has a first terminal 81 thereof connected to the connection node 3 between the first switching element 1 and the second switching element 2 of a corresponding one of the plurality of switching circuits 10. The plurality of bidirectional switches 8 have their respective second terminals 82 connected in common to a common connection node 25. The plurality of resonant capacitors 9 are provided one to one for the plurality of bidirectional switches 8, respectively. Each of the plurality of resonant capacitors 9 is connected between the first terminal 81 of a corresponding one of the plurality of bidirectional switches 8 and the second DC terminal 32. The resonant inductor L1 has a first terminal and a second terminal. The first terminal of the resonant inductor L1 is connected to the common connection node 25. The regenerative element 12 is connected between the second terminal of the resonant inductor L1 and the second DC terminal 32. The controller 50 controls the plurality of first switching elements 1, the plurality of second switching elements 2, and the plurality of bidirectional switches 8. The controller 50 includes a first control unit 51 and a second control unit 52. The first control unit 51 controls the plurality of first switching elements 1 and the plurality of second switching elements 2. The second control unit 52 controls the plurality of bidirectional switches 8. In addition, the power converter 112 further includes the limiter 15 (refer to FIG. 1) of the power converter 100 according to the first embodiment, which is provided for each of the plurality of bidirectional switches 8.

The controller 50 causes each of the plurality of first switching elements 1 and the plurality of second switching elements 2 to make zero-voltage soft switching.

The power converter 112 further includes a protection circuit 17. The power converter 112 further includes a capacitor C10. The capacitor C10 is connected between the first DC terminal 31 and the second DC terminal 32 and is connected to the power converter circuit 11 in parallel.

In the following description, as for the plurality of switching circuits 10, the switching circuits 10 for the U-, V-, and W-phases will be hereinafter referred to as a "switching circuit 10U," a "switching circuit 10V," and a "switching circuit 10W," respectively, for the sake of convenience of description. Also, in the following description, the first switching element 1 and second switching element 2 of the switching circuit 10U will be hereinafter referred to as a "first switching element 1U" and a "second switching element 2D." Likewise, in the following description, the first switching element 1 and second switching element 2 of the switching circuit 10V will be hereinafter referred to as a "first switching element 1V" and a "second switching element 2V" Likewise, in the following description, the first switching element 1 and second switching element 2 of the switching circuit 10W will be hereinafter referred to as a "first switching element 1W" and a "second switching element 2W." Furthermore, in the following description, the connection node 3 between the first switching element 1U and the second switching element 2U will be hereinafter referred to as a "connection node 3U," the connection node 3 between the first switching element 1V and the second switching element 2V will be hereinafter referred to as a "connection node 3V," and the connection node 3 between the first switching element 1W and the second switching element 2W will be hereinafter referred to as a "connection node 3W." Furthermore, in the following description, the AC terminal 41 connected to the connection node 3U will be hereinafter referred to as an "AC terminal 41U," the AC terminal 41 connected to the connection node 3V will be hereinafter referred to as an "AC terminal 41V," and the AC terminal 41 connected to the connection node 3W will be hereinafter referred to as an "AC terminal 41W." Furthermore, in the following description, the resonant capacitor 9 connected to the second switching element 2U in parallel will be hereinafter referred to as a "resonant capacitor 9U," the resonant capacitor 9 connected to the second switching element 2V in parallel will be hereinafter referred to as a "resonant capacitor 9V," and the resonant capacitor 9 connected to the second switching element 2W in parallel will be hereinafter referred to as a "resonant capacitor 9W." Furthermore, in the following description, the bidirectional switch 8 connected to the connection node 3U will be hereinafter referred to as a "bidirectional switch 8U," the bidirectional switch 8 connected to the connection node 3V will be hereinafter referred to as a "bidirectional switch 8V," and the bidirectional switch 8 connected to the connection node 3W will be hereinafter referred to as a "bidirectional switch 8W."

In the power converter 112, the higher-potential output terminal (positive electrode) of the DC power supply E1 is connected to the first DC terminal 31, and the lower-potential output terminal (negative electrode) of the DC power supply E1 is connected to the second DC terminal 32. Also, in the power converter 112, the U-, V, and W-phases of the AC load RA1 are connected to the three AC terminals 41U, 41V, and 41W, respectively.

In the power converter circuit 11, each of the plurality of first switching elements 1 and the plurality of second switching elements 2 has a control terminal, a first main terminal, and a second main terminal. The respective control terminals of the plurality of first switching elements 1 and the plurality of second switching elements 2 are connected to the first control unit 51 of the controller 50. In each of the plurality of switching circuits 10 of the power converter 100, the first main terminal of the first switching element 1 is connected to the first DC terminal 31, the second main terminal of the first switching element 1 is connected to the first main terminal of the second switching element 2, and the second main terminal of the second switching element 2 is connected to the second DC terminal 32. In each of the plurality of switching circuits 10, the first switching element 1 is a high-side switching element (P-side switching element) and the second switching element 2 is a low-side switching element (N-side switching element). Each of the plurality of first switching elements 1 and the plurality of second switching elements 2 may be, for example, an IGBT. Thus, in each of the plurality of first switching elements 1 and the plurality of second switching elements 2, the control terminal, the first main terminal, and the second main terminal are a gate terminal, a collector terminal, and an emitter terminal, respectively. The power converter circuit 11 further includes a plurality of first diodes 4 which are connected one to one in antiparallel to the plurality of first switching elements 1 and a plurality of second diodes 5 which are connected one to one in antiparallel to the plurality of second switching elements 2. In each of the plurality of first diodes 4, the anode of the first diode 4 is connected to the second main terminal (emitter terminal) of the first switching element 1 corresponding to the first diode 4, and the cathode of the first diode 4 is connected to the first main terminal (collector terminal) of the first switching element 1 corresponding to the first diode 4. In each of the plurality of second diodes 5, the anode of the second diode 5 is connected to the second main terminal (emitter terminal) of the second switching element 2 corresponding to the second diode 5, and the cathode of the second diode 5 is connected to the first main terminal (collector terminal) of the second switching element 2 corresponding to the second diode 5.

The U-phase of the AC load RA1 may be connected, for example, to the connection node 3U between the first switching element 1U and the second switching element 2U via the AC terminal 41U. The V-phase of the AC load RA1 may be connected, for example, to the connection node 3V between the first switching element 1V and the second switching element 2V via the AC terminal 41V The W-phase of the AC load RA1 may be connected, for example, to the connection node 3W between the first switching element 1W and the second switching element 2W via the AC terminal 41W.

The plurality of first switching elements 1 and the plurality of second switching elements 2 are controlled by the first control unit 51.

Each of the plurality of resonant capacitors 9 is connected between the first terminal 81 of a corresponding one of the plurality of bidirectional switches 8 and the second DC terminal 32. The power converter 112 includes a plurality of resonant circuits. The plurality of resonant circuits includes a resonant circuit having the resonant capacitor 9U and the resonant inductor L1, a resonant circuit having the resonant capacitor 9V and the resonant inductor L1, and a resonant circuit having the resonant capacitor 9W and the resonant inductor L1. The plurality of resonant circuits shares the resonant inductor L1 in common.

Each of the plurality of bidirectional switches 8 may include, for example, a third switching element 6 and a fourth switching element 7 which are connected in antiparallel to each other. Each of the third switching element 6 and the fourth switching element 7 may be an IGBT, for example. Therefore, in each of the third switching element 6 and the fourth switching element 7, the control terminal, the first main terminal, and the second main terminal are a gate terminal, a collector terminal, and an emitter terminal, respectively. In each of the plurality of bidirectional switches 8, the first main terminal (collector terminal) of the third switching element 6 and the second main terminal (emitter terminal) of the fourth switching element 7 are connected to each other and the second main terminal (emitter terminal) of the third switching element 6 and the first main terminal (collector terminal) of the fourth switching element 7 are connected to each other. In each of the plurality of bidirectional switches 8, the third switching element 6 is connected to the connection node 3 of the switching circuit 10 corresponding to the bidirectional switch 8 including the third switching element 6. In each of the plurality of bidirectional switches 8, the fourth switching element 7 is connected to the connection node 3 of the switching circuit 10 corresponding to the bidirectional switch 8 including the fourth switching element 7. The first terminal 81 of the bidirectional switch 8U is connected to the connection node 3U between the first switching element 1U and the second switching element 2U. The first terminal 81 of the bidirectional switch 8V is connected to the connection node 3V between the first switching element 1V and the second switching element 2V The first terminal 81 of the bidirectional switch 8W is connected to the connection node 3W between the first switching element 1W and the second switching element 2W. In the following description, the third switching element 6 and the fourth switching element 7 of the bidirectional switch 8U will be hereinafter referred to as a "third switching element 6U" and a "fourth switching element 7U," respectively. The third switching element 6 and the fourth switching element 7 of the bidirectional switch 8V will be hereinafter referred to as a "third switching element 6V" and a "fourth switching element 7V," respectively. The third switching element 6 and the fourth switching element 7 of the bidirectional switch 8W will be hereinafter referred to as a "third switching element 6W" and a "fourth switching element 7W," respectively, for the sake of convenience of description.

The plurality of bidirectional switches 8 are controlled by the second control unit 52. In other words, the third switching element 6U, the fourth switching element 7U, the third switching element 6V, the fourth switching element 7V, the third switching element 6W, and the fourth switching element 7W are controlled by the second control unit 52.

The resonant inductor L1 has a first terminal and a second terminal. In the resonant inductor L1, the first terminal of the resonant inductor L1 is connected to the common connection node 25 (in other words, to the respective second terminals 82 of the plurality of bidirectional switches 8) and the second terminal of the resonant inductor L1 is connected to the regenerative element 12.

The regenerative element 12 is connected between the second terminal of the resonant inductor L1 and the second DC terminal 32. The regenerative element 12 may be, for example, a capacitor, more specifically, a film capacitor.

The protection circuit 17 includes a third diode 13 and a fourth diode 14. The third diode 13 is connected between the common connection node 25 (in other words, the respective second terminals 82 of the plurality of bidirectional switches 8) and the first DC terminal 31. In the third diode 13, the anode of the third diode 13 is connected to the common connection node 25. Also, in the third diode 13, the cathode of the third diode 13 is connected to the first DC terminal 31. The fourth diode 14 is connected between the common connection node 25 and the second DC terminal 32. In the fourth diode 14, the anode of the fourth diode 14 is connected to the second DC terminal 32. In the fourth diode 14, the cathode of the fourth diode 14 is connected to the common connection node 25. Thus, the fourth diode 14 is connected to the third diode 13 in series.

The capacitor C10 is connected between the first DC terminal 31 and the second DC terminal 32 and is connected to the power converter circuit 11 in parallel. The capacitor C10 may be, for example, an electrolytic capacitor.

The controller 50 controls the plurality of first switching elements 1, the plurality of second switching elements 2, and the plurality of bidirectional switches 8. The agent that performs the functions of the controller 50 includes a computer system. The computer system includes either a single computer or a plurality of computers. The computer system may include a processor and a memory as principal hardware components thereof. The computer system serves as the agent that performs the functions of the controller 50 according to the present disclosure by making the processor execute a program stored in the memory of the computer system. The program may be stored in advance in the memory of the computer system. Alternatively, the program may also be downloaded through a telecommunications line or be distributed after having been recorded in a non-transitory storage medium such as a memory card, an optical disc, or a hard disk drive (magnetic disk), any of which is readable for the computer system. The processor of the computer system may be made up of a single or a plurality of electronic circuits including a semiconductor integrated circuit (IC) or a large-scale integrated circuit (LSI). Those electronic circuits may be either integrated together on a single chip or distributed on multiple chips, whichever is appropriate. Those multiple chips may be aggregated together in a single device or distributed in multiple devices without limitation.

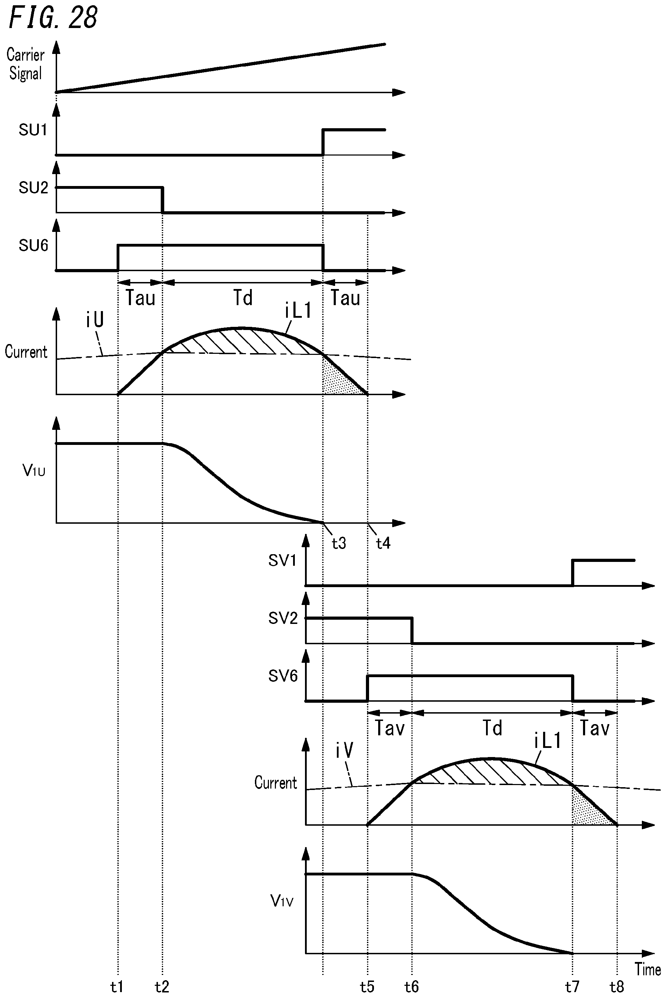

The first control unit 51 of the controller 50 outputs PWM signals SU1, SV1, SW1 to control the ON/OFF states of the plurality of first switching elements 1U, 1V, 1W, respectively. Each of the PWM signals SU1, SV1, SW1 is a signal having, for example, a potential level that alternates between a first potential level (hereinafter referred to as a "low level") and a second potential level (hereinafter referred to as a "high level") higher than the first potential level. The first switching elements 1U, 1V, 1W respectively turn ON when the PWM signals SU1, SV1, SW1 have the high level and respectively turn OFF when the PWM signals SU1, SV1, SW1 have the low level. In addition, the first control unit 51 also outputs PWM signals SU2, SV2, SW2 to control the ON/OFF states of the plurality of second switching elements 2U, 2V, 2W, respectively. Each of the PWM signals SU2, SV2, SW2 is a signal having for example, a potential level that alternates between a first potential level (hereinafter referred to as a "low level") and a second potential level (hereinafter referred to as a "high level") higher than the first potential level The second switching elements 2U, 2V, 2W respectively turn ON when the PWM signals SU2, SV2, SW2 have the high level and respectively turn OFF when the PWM signals SU2, SV2, SW2 have the low level. The first control unit 51 generates, using a carrier signal (refer to FIG. 28) having a saw-tooth waveform, the PWM signals SU1, SV1, SW1 for the plurality of first switching elements 1U, 1V, 1W, respectively, and the PWM signals SU2, SV2, SW2 for the plurality of second switching elements 2U, 2V, 2W, respectively. More specifically, the first control unit 51 generates, based on at least the carrier signal and a U-phase voltage command, the PWM signals SU1, SU2 to be supplied to the first switching element 1U and the second switching element 2U, respectively. Also, the first control unit 51 generates, based on at least the carrier signal and a V-phase voltage command, the PWM signals SV1, SV2 to be supplied to the first switching element 1V and the second switching element 2V, respectively. Furthermore, the first control unit 51 further generates, based on at least the carrier signal and a W-phase voltage command, the PWM signals SW1, SW2 to be supplied to the first switching element 1W and the second switching element 2W, respectively. The U-phase voltage command, the V-phase voltage command, and the W-phase voltage command are sinusoidal wave signals, of which the phases are different from each other by 120 degrees and of which the amplitude (voltage command value) changes with time. Also, the U-phase voltage command, the V-phase voltage command, and the W-phase voltage command each have one cycle of the same length. In addition, one cycle of the U-phase voltage command, the V-phase voltage command, and the W-phase voltage command is longer than one cycle of the carrier signal.

The duty of the PWM signals SU1, SU2 to be supplied from the first control unit 51 to the first switching element 1U and the second switching element 2U, respectively, varies in accordance with the U-phase voltage command. The first control unit 51 generates the PWM signal SU1 to be supplied to the first switching element 1U by comparing the U-phase voltage command with the carrier signal. The first control unit 51 generates the PWM signal SU2 to be supplied to the second switching element 2U by inverting the PWM signal SU1 to be supplied to the first switching element 1U. In addition, to prevent the respective ON periods of the first switching element 1U and the second switching element 2U from overlapping with each other, the first control unit 51 sets a dead time Td (refer to FIG. 28) between a period in which the PWM signal SU1 has the high level and a period in which the PWM signal SU2 has the high level.

The duty of the PWM signals SV1, SV2 to be supplied from the first control unit 51 to the first switching element 1V and the second switching element 2V, respectively, varies in accordance with the V-phase voltage command. The first control unit 51 generates the PWM signal SV1 to be supplied to the first switching element 1V by comparing the V-phase voltage command with the carrier signal. The first control unit 51 generates the PWM signal SV2 to be supplied to the second switching element 2V by inverting the PWM signal SV1 to be supplied to the first switching element 1V. In addition, to prevent the respective ON periods of the first switching element 1V and the second switching element 2V from overlapping with each other, the first control unit 51 sets the dead time Td (refer to FIG. 28) between a period in which the PWM signal SV1 has the high level and a period in which the PWM signal SV2 has the high level.

The duty of the PWM signals SW1, SW2 to be supplied from the first control unit 51 to the first switching element 1W and the second switching element 2W, respectively, varies in accordance with the W-phase voltage command. The first control unit 51 generates the PWM signal SW1 to be supplied to the first switching element 1W by comparing the W-phase voltage command with the carrier signal. The first control unit 51 generates the PWM signal SW2 to be supplied to the second switching element 2W by inverting the PWM signal SW1 to be supplied to the first switching element 1W. In addition, to prevent the respective ON periods of the first switching element 1W and the second switching element 2W from overlapping with each other, the first control unit 51 sets a dead time Td (refer to FIG. 29) between a period in which the PWM signal SW1 has the high level and a period in which the PWM signal SW2 has the high level.

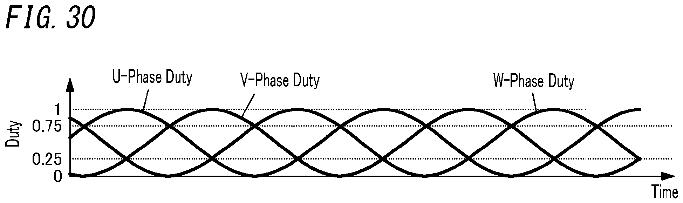

The U-phase voltage command, the V-phase voltage command, and the W-phase voltage command may be, for example, sinusoidal wave signals, of which the phases are different from each other by 120 degrees and of which the amplitude changes with time. Thus, the respective duties of the PWM signals SU1, SV1, SW1 change in the form of sinusoidal waves, of which the phases are different from each other by 120 degrees, as shown in FIG. 30, for example. In the same way, the respective duties of the PWM signals SU2, SV2, SW2 also change in the form of sinusoidal waves, of which the phases are different from each other by 120 degrees.

The first control unit 51 generates the respective PWM signals SU1, SU2, SV1, SV2, SW1, SW2 based on the carrier signal, the respective voltage commands, and information about the state of the AC load RA1. For example, if the AC load RA1 is a three-phase motor, the information about the state of the AC load RA1 may include, for example, detection values provided by a plurality of current sensors for respectively detecting currents flowing through the U-, V-, and W-phases of the AC load RA1.

The plurality of bidirectional switches 8, the resonant inductor L1, the plurality of resonant capacitors 9, the regenerative element 12, and the protection circuit 17 are provided to make zero-voltage soft switching of the plurality of first switching elements 1 and the plurality of second switching elements 2.

In this power converter 112, the controller 50 controls not only the plurality of first switching elements 1 and the plurality of second switching elements 2 of the power converter circuit 11 but also the plurality of bidirectional switches 8 as well. More specifically, the first control unit 51 of the controller 50 controls the plurality of first switching elements 1 and the plurality of second switching elements 2 of the power converter circuit 11 and the second control unit 52 of the controller 50 controls the plurality of bidirectional switches 8.

The second control unit 52 generates control signals SU6, SU7, SV6, SV7, SW6, SW7 for controlling the respective ON/OFF states of the third switching element 6U, the fourth switching element 7U, the third switching element 6V, the fourth switching element 7V, the third switching element 6W, and the fourth switching element 7W, respectively, and outputs the control signals SU6, SU7, SV6, SV7, SW6, SW7 to the respective control terminals (i.e., gate terminals) of the third switching element 6U, the fourth switching element 7U, the third switching element 6V, the fourth switching element 7V, the third switching element 6W, and the fourth switching element 7W.

If the third switching element 6U is ON and the fourth switching element 7U is OFF, the bidirectional switch 8U allows a charging current that flows through the regenerative element 12, the resonant inductor L1, the bidirectional switch 8U, and the resonant capacitor 9U in this order to charge the resonant capacitor 9U to pass therethrough. On the other hand, if the third switching element 6U is OFF and the fourth switching element 7U is ON, the bidirectional switch 8U allows a discharging current that flows through the resonant capacitor 9U, the bidirectional switch 8U, the resonant inductor L1, and the regenerative element 12 in this order to remove electric charges from the resonant capacitor 9U to pass therethrough.

If the third switching element 6V is ON and the fourth switching element 7V is OFF, the bidirectional switch 8V allows a charging current that flows through the regenerative element 12, the resonant inductor L1, the bidirectional switch 8V, and the resonant capacitor 9V in this order to charge the resonant capacitor 9V to pass therethrough. On the other hand, if the third switching element 6V is OFF and the fourth switching element 7V is ON, the bidirectional switch 8V allows a discharging current that flows through the resonant capacitor 9V, the bidirectional switch 8V, the resonant inductor L1, and the regenerative element 12 in this order to remove electric charges from the resonant capacitor 9V to pass therethrough.

If the third switching element 6W is ON and the fourth switching element 7W is OFF, the bidirectional switch 8W allows a charging current that flows through the regenerative element 12, the resonant inductor L1, the bidirectional switch 8W, and the resonant capacitor 9W in this order to charge the resonant capacitor 9W to pass therethrough. On the other hand, if the third switching element 6W is OFF and the fourth switching element 7W is ON, the bidirectional switch 8W allows a discharging current that flows through the resonant capacitor 9W, the bidirectional switch 8W, the resonant inductor L1, and the regenerative element 12 in this order to remove electric charges from the resonant capacitor 9W to pass therethrough.

In the following description, a current flowing through the resonant inductor L1 will be hereinafter designated by iL1, a current flowing through the U-phase of the AC load RA1 will be hereinafter designated by iU, a current flowing through the V-phase of the AC load RA1 will be hereinafter designated by iV, and a current flowing through the W-phase of the AC load RA1 will be hereinafter designated by iW. Also, in the following description, as for each of these currents iL1, iU, iV, and iW, if the current flows in the direction indicated by a corresponding one of the arrows shown in FIG. 27, then the polarity of the current is supposed to be positive. On the other hand, if the current flows in the direction opposite from the one indicated by the arrow shown in FIG. 27, then the polarity of the current is supposed to be negative.

The power converter 112 includes the protection circuit 17 including the third diode 13 and the fourth diode 14 as described above. Thus, in this power converter 112, when the third switching element 6U of the bidirectional switch 8U turns OFF in a state where the third switching element 6U of the bidirectional switch 8U is ON and the positive current iL1 is flowing through the resonant inductor L1, for example, the current iL1 flowing through the resonant inductor L1 is regenerated to the power converter circuit 11 via the third diode 13 until the current iL1 flowing through the resonant inductor L1 goes zero due to the consumption of energy of the resonant inductor L1. Also, in this power converter 112, when the fourth switching element 7U of the bidirectional switch 8U turns OFF in a state where the fourth switching element 7U of the bidirectional switch 8U is ON and the negative current iL1 is flowing through the resonant inductor L1, for example, a current flows along the path passing through the fourth diode 14, the resonant inductor L1, and the regenerative element 12 in this order until the current iL1 flowing through the resonant inductor L1 goes zero due to the consumption of energy of the resonant inductor L1. Furthermore, in this power converter 112, when the third switching element 6V of the bidirectional switch 8V turns OFF in a state where the third switching element 6V of the bidirectional switch 8V is ON and the positive current iL1 is flowing through the resonant inductor L1, for example, the current iL1 flowing through the resonant inductor L1 is regenerated to the power converter circuit 11 via the third diode 13 until the current iL1 flowing through the resonant inductor L1 goes zero due to the consumption of energy of the resonant inductor L1. Furthermore, in this power converter 112, when the fourth switching element 7V of the bidirectional switch 8V turns OFF in a state where the fourth switching element 7V of the bidirectional switch 8V is ON and the negative current iL1 is flowing through the resonant inductor L1, for example, a current flows along the path passing through the fourth diode 14, the resonant inductor L1, and the regenerative element 12 in this order until the current iL1 flowing through the resonant inductor L1 goes zero due to the consumption of energy of the resonant inductor L1. Furthermore, in this power converter 112, when the third switching element 6W of the bidirectional switch 8W turns OFF in a state where the third switching element 6W of the bidirectional switch 8W is ON and the positive current iL1 is flowing through the resonant inductor L1, for example, the current iL1 flowing through the resonant inductor L1 is regenerated to the power converter circuit 11 via the third diode 13 until the current iL1 flowing through the resonant inductor L1 goes zero due to the consumption of energy of the resonant inductor L1. Furthermore, in this power converter 112, when the fourth switching element 7W of the bidirectional switch 8W turns OFF in a state where the fourth switching element 7W of the bidirectional switch 8W is ON and the negative current iL1 is flowing through the resonant inductor L1, for example, a current flows along the path passing through the fourth diode 14, the resonant inductor L1, and the regenerative element 12 in this order until the current iL1 flowing through the resonant inductor L1 goes zero due to the consumption of energy of the resonant inductor L1.

Next, it will be described with reference to FIGS. 27 and 28 how the first control unit 51 operates when performing zero-voltage soft switching control on each of the plurality of first switching elements 1. Note that when performing zero-voltage soft switching control on each of the plurality of second switching elements 2, the first control unit 51 operates in the same way as when performing zero-voltage soft switching control on each of the plurality of first switching elements 1, and therefore, description thereof will be omitted herein.

When the zero-voltage soft switching control is performed on the first switching element 1, the voltage across the first switching element 1 needs to be reduced to zero just before the first switching element 1 turns ON. Thus, the first control unit 51 reduces the voltage across the first switching element 1 as the target of the zero-voltage soft switching control to zero by turning the third switching element 6 corresponding to the first switching element 1 ON to cause the resonant capacitor 9, which is connected to the resonant inductor L1 and the first switching element 1 in series, to produce resonance and thereby charge the resonant capacitor 9 with the electric charges stored in the regenerative element 12.

On the other hand, when the zero-voltage soft switching control is performed on the second switching element 2, the voltage across the second switching element 2 needs to be reduced to zero just before the second switching element 2 turns ON. Thus, the controller 50 reduces the voltage across the second switching element 2 as the target of the zero-voltage soft switching control to zero by making the second control unit 52 turn the fourth switching element 7 corresponding to the second switching element 2 ON to cause the resonant capacitor 9, which is connected to the resonant inductor L1 and the second switching element 2 in parallel, to produce resonance and thereby remove the electric charges from the resonant capacitor 9 to the capacitor C1. The controller 50 charges and discharges the resonant capacitor 9 via the bidirectional switch 8 such that the dead time Td agrees with a half cycle $(\pi \times \sqrt{LC})$ of LC resonance. This allows the power converter 100 to make zero-voltage soft switching.

The PWM signals SU1, SU2 to be respectively supplied from the first control unit 51 to the first switching element 1U and the second switching element 2U of the switching circuit 10U are shown in FIG. 28. In addition, the control signal SU6 to be supplied from the second control unit 52 to the third switching element 6U of the bidirectional switch 8U, the current iU flowing through the U-phase of the AC load RA1, the current iL1 flowing through the resonant inductor L1, and the voltage $V_{1U}$ across the first switching element 1U are also shown in FIG. 28. Furthermore, the PWM signals SV1, SV2 to be respectively supplied from the first control unit 51 to the first switching element 1V and the second switching element 2V of the switching circuit 10V are also shown in FIG. 28. In addition, the control signal SV6 to be supplied from the second control unit 52 to the third switching element 6V of the bidirectional switch 8V, the current iV flowing through the V-phase of the AC load RA1, the current iL1 flowing through the resonant inductor L1, and the voltage Viv across the first switching element 1V are also shown in FIG. 28.

Furthermore, the dead time Td that the first control unit 51 sets to prevent the first switching element 1 and the second switching element 2 of the same phase from turning ON simultaneously is also shown in FIG. 28. Besides, an additional time Tau set by the second control unit 52 with respect to the control signal SU6 for the third switching element 6U of the bidirectional switch 8U and an additional time Tav set by the second control unit 52 with respect to the control signal SV6 for the third switching element 6V of the bidirectional switch 8V are also shown in FIG. 28.

The PWM signals SW1, SW2 to be respectively supplied from the first control unit 51 to the first switching element 1W and the second switching element 2W of the switching circuit 10W are shown in FIG. 29. In addition, the control signal SW6 to be supplied from the second control unit 52 to the third switching element 6W of the bidirectional switch 8W and the current iW flowing through the W-phase of the AC load RA1 are also shown in FIG. 29. The current iL1 flowing through the resonant inductor L1 is also shown in FIG. 29. The voltage $V_{1W}$ across the first switching element 1W is also shown in FIG. 29.

Furthermore, the dead time Td that the first control unit 51 sets to prevent the first switching element 1W and the second switching element 2W from turning ON simultaneously is also shown in FIG. 29. Besides, an additional time Taw set by the second control unit 52 with respect to the control signal SW6 for the third switching element 6W of the bidirectional switch 8W is also shown in FIG. 29.

The additional time Tau (refer to FIG. 28) is an amount of time that the second control unit 52 provides to make the high-level period of the control signal SU6 longer than the dead time Td. To prevent the first switching element 1U and the second switching element 2U from turning ON simultaneously, the second control unit 52 sets the beginning t1 of the high-level period of the control signal SU6 to be supplied to the third switching element 6U of the bidirectional switch 8U at a point in time earlier than the beginning (point in time t2) of the dead time Td provided. The length of the additional time Tau is determined by the value of the current iU. To start producing the LC resonance from the beginning (point in time t2) of the dead time Td, it is preferable that the value of the current iL1 agree with the value of the current iU at the beginning (point in time t2) of the dead time Td. This is because as long as iL1 < iU is satisfied, all current flows through the AC load RA1, and therefore, the resonant capacitor 9U cannot be charged. The end of the high-level period of the control signal SU6 may be simultaneous with, or later than, the end (point in time t3) of the dead time Td. In the example shown in FIG. 28, the end of the high-level period of the control signal SU6 is set to be simultaneous with the end (point in time t3) of the dead time Td. The second control unit 52 sets the high-level period of the control signal SU6 at Tau + Td. The voltage $V_{1U}$ across the first switching element 1U goes zero at the end (point in time t3) of the dead time Td. In the example shown in FIG. 28, the current iL1 starts flowing through the resonant inductor L1 at the beginning t1 of the high-level period of the control signal SU6 and goes zero at a time t4 when the additional time Tau has passed since the end (point in time t3) of the dead time Td. At this time, the current iL1 satisfies iL1 ≥ iU from the beginning (point in time t2) of the dead time Td, and therefore, the current iL1 in the shaded part of the current waveform shown as the fifth waveform from the top of FIG. 28 flows into the resonant capacitor 9U to produce the LC resonance. From the end (point in time t3) of the dead time Td and on, the current iL1 is regenerated to the power converter circuit 11 via the third diode 13.

The additional time Tav (refer to FIG. 28) is an amount of time that the second control unit 52 provides to make the high-level period of the control signal SV6 longer than the dead time Td. The second control unit 52 sets the beginning t5 of the high-level period of the control signal SV6 to be supplied to the third switching element 6V of the bidirectional switch 8V at a point in time earlier than the beginning (point in time t6) of the dead time Td provided to make high-level period of the control signal SV6 longer than the dead time Td provided to prevent the first switching element 1V and the second switching element 2V from turning ON simultaneously. The length of the additional time Tav is determined by the value of the current iV. To start producing the LC resonance from the beginning (point in time t6) of the dead time Td, it is preferable that the value of the current iL1 agree with the value of the current iV at the beginning (point in time t6) of the dead time Td. This is because as long as iL1 < iV is satisfied, all current flows through the AC load RA1, and therefore, the resonant capacitor 9V cannot be charged. The end of the high-level period of the control signal SV6 may be simultaneous with, or later than, the end (point in time t7) of the dead time Td. In the example shown in FIG. 28, the end of the high-level period of the control signal SV6 is set to be simultaneous with the end (point in time t7) of the dead time Td. The second control unit 52 sets the high-level period of the control signal SV6 at Tav + Td. The voltage Viv across the first switching element 1V goes zero at the end (point in time t7) of the dead time Td. In the example shown in FIG. 28, the current iL1 starts flowing through the resonant inductor L1 at the beginning t5 of the high-level period of the control signal SV6 and goes zero at a time t8 when the additional time Tav has passed since the end (point in time t7) of the dead time Td. At this time, the current iL1 satisfies iL1 ≥ iV from the beginning (point in time t6) of the dead time Td and on, and therefore, the current iL1 in the shaded part of the current waveform shown as the tenth waveform from the top of FIG. 28 flows into the resonant capacitor 9V to produce the LC resonance. From the end (point in time t7) of the dead time Td and on, the current iL1 is regenerated to the power converter circuit 11 via the third diode 13.

The additional time Taw is an amount of time that the second control unit 52 provides to make the high-level period of the control signal SW6 longer than the dead time Td. The second control unit 52 sets the beginning t9 of the high-level period of the control signal SW6 to be supplied to the third switching element 6W of the bidirectional switch 8W at a point in time earlier than the beginning (point in time t10) of the dead time Td provided to make the high-level period of the control signal SW6 longer than the dead time Td provided to prevent the first switching element 1W and the second switching element 2W from turning ON simultaneously. The length of the additional time Taw is determined by the value of the current iW. To start producing the LC resonance from the beginning (point in time t10) of the dead time Td, it is preferable that the value of the current iL1 agree with the value of the current iW at the beginning (point in time t10) of the dead time. This is because as long as iL1 < iW is satisfied, all current flows through the AC load RA1, and therefore, the resonant capacitor 9W cannot be charged. The end of the high-level period of the control signal SW6 may be simultaneous with, or later than, the end (point in time t11) of the dead time Td. In the example shown in FIG. 29, the end of the high-level period of the control signal SW6 is set to be simultaneous with the end (point in time t11) of the dead time Td. The second control unit 52 sets the high-level period of the control signal SW6 at Taw + Td. The voltage $V_{1W}$ across the first switching element 1W goes zero at the end (point in time t11) of the dead time Td. In the example shown in FIG. 29, the current iL1 starts flowing through the resonant inductor L1 at the beginning t9 of the high-level period of the control signal SW6 and goes zero at a time 112 when the additional time Taw has passed since the end (point in time t11) of the dead time Td. At this time, the current iL1 satisfies iL1 ≥ iW from the beginning (point in time t10) of the dead time Td and on, and therefore, the current iL1 in the shaded part of the current waveform shown as the fourth waveform from the top of FIG. 29 flows into the resonant capacitor 9W to produce the LC resonance. From the end (point in time t11) of the dead time Td and on, the current iL1 is regenerated to the power converter circuit 11 via the third diode 13.

To start producing the LC resonance at the beginning t1 of the dead time Td as described above, the second control unit 52 determines the additional time Tau based on the current iU such that iL1 = iU is satisfied at the beginning t1 of the dead time Td. More specifically, using either the detection result of the current iU by a current sensor or a signal processing value thereof, or an estimated value of the current iU, the inductance L of the resonant inductor L1 that has been stored in advance, and the detection result of the voltage V12 across the regenerative element 12, for example, the second control unit 52 determines the additional time Tau by the equation: Tau = iU × (L/V12). In this case, as the detection result of the current iU or the signal processing value thereof, either a detection value at a carrier cycle at which the additional time Tau is added or a detection value at a timing closest to the carrier cycle may be used. Also, in this case, as the estimated value of the current iU, a value of the current iU estimated at the carrier cycle at which the additional time Tau is added may be used, for example.

To start producing the LC resonance at the beginning (point in time t6) of the dead time Td as described above, the second control unit 52 determines the additional time Tav based on the current iV such that iL1 = iV is satisfied at the beginning (point in time t6) of the dead time Td. More specifically, using either the detection result of the current iV by a current sensor or a signal processing value thereof, or an estimated value of the current iV, the inductance L of the resonant inductor L1 that has been stored in advance, and the detection result of the voltage V12 across the regenerative element 12, for example, the second control unit 52 determines the additional time Tav by the equation: Tav = iV × (L/V12). In this case, as the detection result of the current iV or the signal processing value thereof, either a detection value at a carrier cycle at which the additional time Tav is added or a detection value at a timing closest to the carrier cycle may be used. Also, in this case, as the estimated value of the current iV, a value of the current iV estimated at the carrier cycle at which the additional time Tav is added may be used, for example.

The second control unit 52 determines the additional time Taw based on the current iW. More specifically, using the detection result of the current iW by a current sensor, the inductance L of the resonant inductor L1 that has been stored in advance, and the detection result of the voltage V12 across the regenerative element 12, for example, the second control unit 52 determines the additional time Taw by the equation: Taw = iW × (L/V12). In this case, as the detection result of the current iW or the signal processing value thereof, either a detection value at a carrier cycle at which the additional time Taw is added or a detection value at a timing closest to the carrier cycle may be used. Also, in this case, as the estimated value of the current iW, a value of the current iW estimated at the carrier cycle at which the additional time Taw is added may be used, for example.

Suppose the respective capacitances of the plurality of resonant capacitors 9U, 9V, and 9W are designated by Cru, Crv, and Crw, respectively. In that case, if a U-phase current and a V-phase current flow simultaneously through the resonant inductor L1, a capacitor having a combined capacitance (= Cru + Crv) of the resonant capacitor 9U and the resonant capacitor 9V is connected to the resonant inductor L1 in series in an equivalent circuit. Thus, in the power converter 112, if two-phase currents flow simultaneously through the resonant inductor L1, then the resonant frequency of a resonant circuit including the resonant inductor L1 changes compared to a situation where a single-phase current flows through the resonant inductor L1. Consequently, the power converter 112 cannot make zero-voltage soft switching.

In contrast, in the power converter 112, when determining that two-phase resonant currents corresponding to two switching circuits 10 belonging to the plurality of switching circuits 10 flow simultaneously through the resonant inductor L1, the controller 50 performs the control of shifting the respective ON periods of the first switching element 1 and the second switching element 2 in one of the two switching circuits 10. As used herein, the expression "when determining that two-phase resonant currents flow simultaneously" may also refer to a situation where it has been estimated in advance that the two-phase resonant currents would flow simultaneously through the resonant inductor L1.

FIG. 28 shows an exemplary boundary condition between a situation where the U-phase resonant current and the V-phase resonant current do not overlap with each other (i.e., do not flow simultaneously) and a situation where the U-phase resonant current and the V-phase resonant current overlap with each other (i.e., flow simultaneously). The boundary condition will be described with reference to FIG. 28. In the power converter 112, if the time lag between the beginning (point in time t3) of the high-level period of the PWM signal SU1 to be supplied to the first switching element 1U of the switching circuit 10U and the beginning (point in time t7) of the high-level period of the PWM signal SV1 to be supplied to the first switching element 1V of the switching circuit 10V is equal to or greater than (Tau + Tav + Td), then the U-phase resonant current and the V-phase resonant current do not overlap with each other. On the other hand, if the time lag is less than (Tau + Tav + Td), then the U-phase resonant current and the V-phase resonant current overlap with each other. That is to say, with a threshold value for the time lag set at (Tau + Tav + Td) in accordance with the boundary condition, if the time lag is less than the threshold value, it may be estimated that resonant currents corresponding to the two phases of the switching circuit 10U and the switching circuit 10V belonging to the plurality of switching circuits 10 would flow simultaneously through the resonant inductor L1. Note that this threshold value is only an example, and the threshold value may also be set at any other value. For example, with the error of the additional time Tau and the error of the additional time Tav taken into account, the threshold value may also be set at a value even larger than (Tau + Tav + Td). In addition, the above-described method for calculating the time lag to determine whether the two-phase resonant currents flow simultaneously is only an example. Rather, any other calculating method may also be adopted as long as a time lag corresponding to the time lag described above may be calculated. For example, as the time lag for use to determine whether the two-phase resonant currents flow simultaneously, a time lag between the end (point in time t2) of the high-level period of the PWM signal SU2 to be supplied to the second switching element 2U of the switching circuit 10U and the end (point in time t6) of the high-level period of the PWM signal SV2 to be supplied to the second switching element 2V of the switching circuit 10V may also be used. In the power converter 112, if the above-described boundary condition is adopted, a V-phase (or U-phase) resonant current starts to flow as soon as a U-phase (or V-phase) resonant current has finished flowing.

In the power converter 112, if the time lag between the beginning (point in time t3) of the high-level period of the PWM signal SU1 to be supplied to the first switching element 1U of the switching circuit 10U and the beginning (point in time t11) of the high-level period of the PWM signal SW1 to be supplied to the first switching element 1W of the switching circuit 10W is equal to or greater than (Tau + Taw + Td), then the U-phase resonant current and the W-phase resonant current do not overlap with each other. On the other hand, if the time lag is less than (Tau + Taw + Td), then the U-phase resonant current and the W-phase resonant current overlap with each other. That is to say, with a threshold value for the time lag set at (Tau + Taw + Td) in accordance with the boundary condition, if the time lag is less than the threshold value, it may be estimated that resonant currents corresponding to the two phases of the switching circuit 10U and the switching circuit 10W belonging to the plurality of switching circuits 10 would flow simultaneously through the resonant inductor L1. Note that this threshold value is only an example, and the threshold value may also be set at any other value. For example, with the error of the additional time Tau and the error of the additional time Taw taken into account, the threshold value may also be set at a value even larger than (Tau + Taw + Td). In addition, the above-described method for calculating the time lag to determine whether the two-phase resonant currents flow simultaneously is only an example. Rather, any other calculating method may also be adopted as long as a time lag corresponding to the time lag described above may be calculated. For example, as the time lag for use to determine whether the two-phase resonant currents flow simultaneously, a time lag between the end (point in time t2) of the high-level period of the PWM signal SU2 to be supplied to the second switching element 2U of the switching circuit 10U and the end (point in time t10) of the high-level period of the PWM signal SW2 to be supplied to the second switching element 2W of the switching circuit 10W may also be used.

In the power converter 112, if the time lag between the beginning (point in time t3) of the high-level period of the PWM signal SV1 to be supplied to the first switching element 1V of the switching circuit 10V and the beginning (point in time t11) of the high-level period of the PWM signal SW1 to be supplied to the first switching element 1W of the switching circuit 10W is equal to or greater than (Tav + Taw + Td), then the V-phase resonant current and the W-phase resonant current do not overlap with each other. On the other hand, if the time lag is less than (Tav + Taw + Td), then the V-phase resonant current and the W-phase resonant current overlap with each other. That is to say, with a threshold value for the time lag set at (Tav + Taw + Td) in accordance with the boundary condition, if the time lag is less than the threshold value, it may be estimated that resonant currents corresponding to the two phases of the switching circuit 10V and the switching circuit 10W belonging to the plurality of switching circuits 10 would flow simultaneously through the resonant inductor L1. Note that this threshold value is only an example, and the threshold value may also be set at any other value. For example, with the error of the additional time Tav and the error of the additional time Taw taken into account, the threshold value may also be set at a value even larger than (Tav + Taw + Td). In addition, the above-described method for calculating the time lag to determine whether the two-phase resonant currents flow simultaneously is only an example. Rather, any other calculating method may also be adopted as long as a time lag corresponding to the time lag described above may be calculated. For example, as the time lag for use to determine whether the two-phase resonant currents flow simultaneously, a time lag between the end (point in time t6) of the high-level period of the PWM signal SV2 to be supplied to the second switching element 2V of the switching circuit 10V and the end (point in time t10) of the high-level period of the PWM signal SW2 to be supplied to the second switching element 2W of the switching circuit 10W may also be used.

The power converter 112 according to the thirteenth embodiment provides each of the plurality of bidirectional switches 8 with the same limiter 15 (refer to FIG. 1) as that of the power converter 100 according to the first embodiment.

The power converter 112 according to the thirteenth embodiment includes a plurality of limiters 15 provided one to one for the plurality of bidirectional switches 8. This allows, when making soft switching of each of the plurality of first switching elements 1 and the plurality of second switching elements 2, the absolute value of the voltage variation rate of the voltage V8 applied to a corresponding bidirectional switch 8 to be limited to a threshold value or less. Thus, the power converter 112 according to the thirteenth embodiment may reduce, when making soft switching of each of the plurality of first switching elements 1 and the plurality of second switching elements 2, the radiation noise to be caused due to a variation in the voltage V8 applied to its corresponding bidirectional switch 8.

Note that the power converter 112 according to the thirteenth embodiment does not have to include the limiter 15 of the power converter 100 according to the first embodiment but may also include, for example, the limiter 15 of the power converter 101-105 according to any one of the second to sixth embodiments described above. In addition, the bidirectional switch 8 may have the same configuration as, for example, the bidirectional switch 8 of the power converter 106, 109-111 according to any one of the seventh, tenth, eleventh, and twelfth embodiments described above.

Optionally, the power converter 112 according to the thirteenth embodiment, as well as the power converter 107 (refer to FIG. 22) according to the eighth embodiment, may include the capacitor 19.

Furthermore, in the power converter 112 according to the thirteenth embodiment, as in the power converter 108 (refer to FIG. 23) according to the ninth embodiment described above, the regenerative element 12 may also be a constant voltage source.

(Fourteenth embodiment)

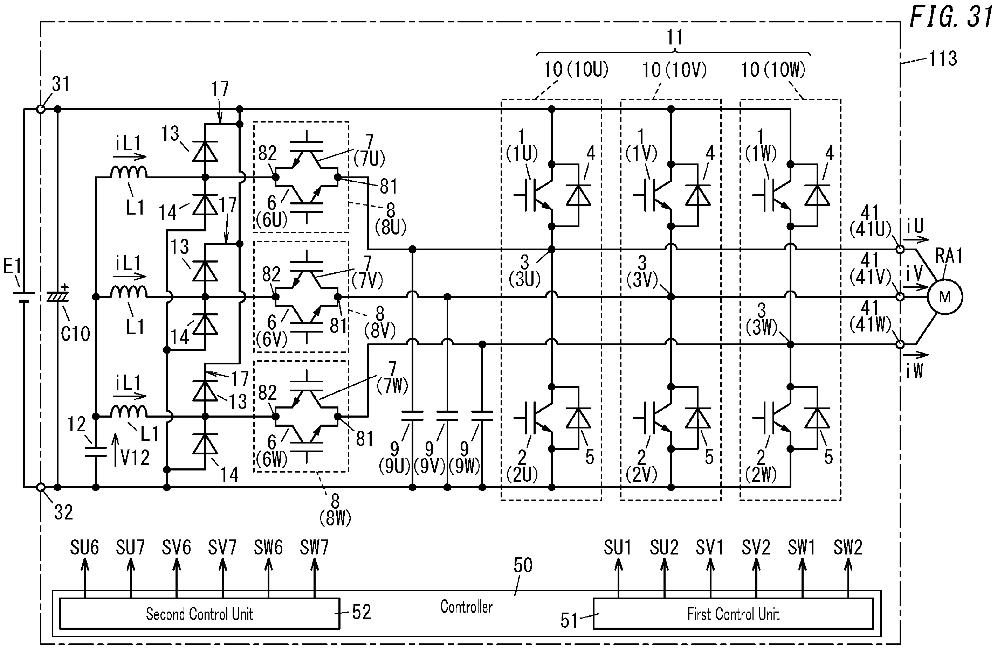

Next, a power converter 113 according to a fourteenth embodiment will be described with reference to FIG. 31. The power converter 112 according to the fourteenth embodiment includes a plurality of (e.g., three) resonant inductors L1 and a plurality of (e.g., three) protection circuits 17, in each of which a third diode 13 and a fourth diode 14 are connected in series, which is a difference from the power converter 112 (refer to FIG. 27) according to the thirteenth embodiment described above. In the following description, any constituent element of the power converter 113 according to this fourteenth embodiment, having the same function as a counterpart of the power converter 112 according to the thirteenth embodiment described above, will be designated by the same reference numeral as that counterpart's, and description thereof will be omitted herein.

In the power converter 113, the plurality of (e.g., three) resonant inductors L1 are connected one to one to the plurality of (e.g., three) bidirectional switches 8. A first terminal of each of the plurality of (e.g., three) resonant inductors L1 is connected to the second terminal 82 of a corresponding one of the plurality of (e.g., three) bidirectional switches 8.

The respective second terminals of the plurality of resonant inductors L1 are connected in common to the single regenerative element 12.

The plurality of protection circuits 17 are connected between the first DC terminal 31 and the second DC terminal 32. The plurality of protection circuits 17 are provided one to one for the plurality of bidirectional switches 8. The connection node between the third diode 13 and the fourth diode 14 of each protection circuit 17 is connected to the second terminal 82 of a corresponding one of the bidirectional switches 8.

The power converter 113 according to the fourteenth embodiment provides each of the plurality of bidirectional switches 8 with the same limiter 15 (refer to FIG. 1) as that of the power converter 100 according to the first embodiment.

The power converter 113 according to the fourteenth embodiment includes a plurality of limiters 15 provided one to one for the plurality of bidirectional switches 8. This allows, when making soft switching of each of the plurality of first switching elements 1 and the plurality of second switching elements 2, the absolute value of the voltage variation rate of the voltage V8 applied to a corresponding bidirectional switch 8 to be limited to a threshold value or less. Thus, the power converter 113 according to the fourteenth embodiment may reduce, when making soft switching of each of the plurality of first switching elements 1 and the plurality of second switching elements 2, the radiation noise to be caused due to a variation in the voltage V8 applied to its corresponding bidirectional switch 8.

Note that in the power converter 113 according to the fourteenth embodiment, the plurality of resonant inductors L1 are provided one to one for the plurality of switching circuits 10. This enables preventing two-phase resonant currents from flowing through a single resonant inductor L1.

Note that the power converter 113 according to the fourteenth embodiment does not have to include the limiter 15 of the power converter 100 according to the first embodiment but may also include, for example, the limiter 15 of the power converter 101-105 according to any one of the second to sixth embodiments described above. In addition, the bidirectional switch 8 may have the same configuration as, for example, the bidirectional switch 8 of the power converter 106, 109-111 according to any one of the seventh, tenth, eleventh, and twelfth embodiments described above.

Optionally, the power converter 113 according to the fourteenth embodiment, as well as the power converter 107 (refer to FIG. 22) according to the eighth embodiment, may include the capacitor 19.

Furthermore, in the power converter 113 according to the fourteenth embodiment, as in the power converter 108 (refer to FIG. 23) according to the ninth embodiment described above, the regenerative element 12 may also be a constant voltage source.

(Variations)

Note that the first to fourteenth embodiments and their variations described above are only exemplary ones of various embodiments of the present disclosure and their variations and should not be construed as limiting. Rather, the first to fourteenth embodiments and their variations may be readily modified in various manners depending on a design choice or any other factor without departing from the scope of the present disclosure.

For example, each of the first switching element 1 and the second switching element 2 does not have to be an IGBT but may also be a MOSFET. In that case, the first diode 4 may be replaced with, for example, a parasitic diode for the MOSFET serving as the first switching element 1. The second diode 5 may be replaced with, for example, a parasitic diode for the MOSFET serving as the second switching element 2. The MOSFET may be, for example, an Si-based MOSFET or an SiC-based MOSFET. Each of the first switching element 1 and the second switching element 2 may also be, for example, a bipolar transistor or a GaN-based GIT.

Also, in the power converters 100-113, if the resonant capacitor 9 has relatively small capacitance, then the resonant capacitor 9 does not have to be provided as an external component but the parasitic capacitance across the second switching element 2 may also serve as the resonant capacitor 9.

(Aspects)

The first to fourteenth embodiments and their variations described above are specific implementations of the following aspects of the present disclosure.

A power converter (100; 101; 102; 103; 104; 105; 106; 107; 108; 109; 110; 111; 112; 113) according to a first aspect includes a first DC terminal (31) and a second DC terminal (32), a power converter circuit (11), a bidirectional switch (8), a resonant capacitor (9), a resonant inductor (L1), a regenerative element (12), a first control unit (51), a second control unit (52), and a limiter (15). The power converter circuit (11) includes: a first switching element (1) and a second switching element (2) which are connected to each other in series; a first diode (4) connected in antiparallel to the first switching element (1); and a second diode (5) connected in antiparallel to the second switching element (2). In the power converter circuit (11), the first switching element (1) is connected to the first DC terminal (31) and the second switching element (2) is connected to the second DC terminal (32). The bidirectional switch (8) has a first terminal (81) and a second terminal (82). The bidirectional switch (8) has the first terminal (81) connected to a connection node (3) between the first switching element (1) and the second switching element (2). The resonant capacitor (9) is connected between the first terminal (81) of the bidirectional switch (8) and the second DC terminal (32). The resonant inductor (L1) is connected to the second terminal (82) of the bidirectional switch (8). The regenerative element (12) is connected between the resonant inductor (L1) and the second DC terminal (32). The first control unit (51) controls the first switching element (1) and the second switching element (2). The second control unit (52) controls the bidirectional switch (8). The limiter (15) limits an absolute value of a voltage variation rate of a voltage applied between the first and second terminals (81, 82) of the bidirectional switch (8) to a threshold value or less.

The power converter (100; 101; 102; 103; 104; 105; 106; 107; 108; 109; 110; 111; 112; 113) according to the first aspect may reduce the radiation noise.

In a power converter (100; 107; 108; 109; 112; 113) according to a second aspect, which may be implemented in conjunction with the first aspect, the bidirectional switch (8) includes a third switching element (6) and a fourth switching element (7), each of which has a first main terminal, a second main terminal, and a control terminal. The second control unit (52) includes: a first drive circuit (521) connected between the control terminal and the second main terminal of the third switching element (6); and a second drive circuit (522) connected between the control terminal and the second main terminal of the fourth switching element (7). The limiter (15) includes: a first resistor (R1) connected between the control terminal of the third switching element (6) and the first drive circuit (521); and a second resistor (R2) connected between the control terminal of the fourth switching element (7) and the second drive circuit (522). The limiter (15) determines in advance a resistance value of the first resistor (R1) and a resistance value of the second resistor (R2) to make the absolute value of the voltage variation rate when the bidirectional switch (8) turns from OFF to ON equal to or less than the threshold value.

The power converter (100; 107; 108; 109; 112; 113) according to the second aspect may reduce, when making soft switching of the first switching element (1) and the second switching element (2), the absolute value of the voltage variation rate of the voltage (V8) of the bidirectional switch (8) when the bidirectional switch (8) turns from OFF to ON, thus enabling reducing the radiation noise.

In a power converter (101; 107; 108; 112; 113) according to a third aspect, which may be implemented in conjunction with the first aspect, the bidirectional switch (8) includes a third switching element (6) and a fourth switching element (7), each of which has a first main terminal, a second main terminal, and a control terminal. The second control unit (52) includes: a first drive circuit (521) connected between the control terminal and the second main terminal of the third switching element (6); and a second drive circuit (522) connected between the control terminal and the second main terminal of the fourth switching element (7). The limiter (15) includes: a first capacitor (C6) connected between the control terminal and the first main terminal of the third switching element (6); and a second capacitor (C7) connected between the control terminal and the first main terminal of the fourth switching element (7). The limiter (15) determines in advance a capacitance of the first capacitor (C6) and a capacitance of the second capacitor (C7) to make the absolute value of the voltage variation rate when the bidirectional switch (8) turns from OFF to ON equal to or less than the threshold value.

The power converter (101; 107; 108; 112; 113) according to the third aspect may reduce, when making soft switching of the first switching element (1) and the second switching element (2), the absolute value of the voltage variation rate of the voltage (V8) applied to the bidirectional switch (8) when the bidirectional switch (8) turns from OFF to ON, thus enabling reducing the radiation noise.

In a power converter (102; 107; 108; 112; 113) according to a fourth aspect, which may be implemented in conjunction with the first aspect, the limiter (15) includes a capacitor (C8) connected to the bidirectional switch (8) in parallel. The limiter (15) determines in advance a capacitance of the capacitor (C8) to make the absolute value of the voltage variation rate when the bidirectional switch (8) turns from ON to OFF equal to or less than the threshold value.

The power converter (102; 107; 108; 112; 113) according to the fourth aspect may reduce the absolute value of the voltage variation rate when the bidirectional switch (8) turns from ON to OFF, thus enabling reducing the radiation noise.

In a power converter (103; 107; 108; 112; 113) according to a fifth aspect, which may be implemented in conjunction with the first aspect, the limiter (15) includes a capacitor (C1) connected to the resonant inductor (L1) in parallel. The limiter (15) determines in advance a capacitance of the capacitor (C1) to make the absolute value of the voltage variation rate when the bidirectional switch (8) turns from ON to OFF equal to or less than the threshold value.

The power converter (103; 107; 108; 112; 113) according to the fifth aspect may reduce the absolute value of the voltage variation rate when the bidirectional switch (8) turns from ON to OFF, thus enabling reducing the radiation noise.

A power converter (104; 107; 108; 112; 113) according to a sixth aspect, which may be implemented in conjunction with the first aspect, further includes a third diode (13) and a fourth diode (14). The third diode (13) has an anode connected to the connection node between the bidirectional switch (8) and the resonant inductor (L1) and has a cathode connected to the first DC terminal (31). The fourth diode (14) has an anode connected to the connection node between the bidirectional switch (8) and the resonant inductor (L1) and has a cathode connected to the second DC terminal (32). The limiter (15) includes: a first capacitor (C13) connected to the third diode (13) in parallel; and a second capacitor (C14) connected to the fourth diode (14) in paralle1. The limiter (15) determines in advance a capacitance of the first capacitor (C13) and a capacitance of the second capacitor (C14) to make the absolute value of the voltage variation rate when the bidirectional switch (8) turns from ON to OFF equal to or less than the threshold value.

The power converter (104; 107; 108; 112; 113) according to the sixth aspect may reduce the absolute value of the voltage variation rate when the bidirectional switch (8) turns from ON to OFF, thus enabling reducing the radiation noise.

In a power converter (105; 107; 108; 112; 113) according to a seventh aspect, which may be implemented in conjunction with the first aspect, the resonant inductor (L1) has a nonlinear characteristic that makes inductance (Lr + Ls) of the resonant inductor (L1) at a value equal to or less than a current threshold value (Ith) larger than inductance (Lr) of the resonant inductor (L1) at a current value of the resonant current. The current threshold value (Ith) is less than the current value of a resonant current. The resonant inductor (L1) serves as the limiter (15) as well.

The power converter (105; 107; 108; 112; 113) according to the seventh aspect may cut down the switching loss when the bidirectional switch (8) turns from OFF to ON without changing the resonant frequency when making soft switching of the first switching element (1) and the second switching element (2). In addition, the power converter (105; 107; 108; 112; 113) according to the seventh aspect may also reduce the absolute value of the voltage variation rate when the bidirectional switch (8) turns from ON to OFF, thus enabling reducing the radiation noise.

In a power converter (106; 107; 108; 112; 113) according to an eighth aspect, which may be implemented in conjunction with the first aspect, the bidirectional switch (8) includes a third switching element (6) and a fourth switching element (7) which are connected to each other in anti-series. Each of the third switching element (6) and the fourth switching element (7) has a first main terminal, a second main terminal, and a control terminal. Each of the third switching element (6) and the fourth switching element (7) is a unipolar transistor. The second control unit (52) is configured to turn the third switching element (6) and the fourth switching element (7) OFF at a timing when a current (iL1) flowing through the resonant inductor (L1) goes zero. The second control unit (52) serves as the limiter (15) as well.

The power converter (106; 107; 108; 112; 113) according to an eighth aspect may reduce the absolute value of the voltage variation rate when the bidirectional switch (8) turns from ON to OFF, thus enabling reducing the radiation noise.

**Reference Signs List**

| | |
|---|---|
| 1 | First Switching Element |
| 2 | Second Switching Element |
| 3 | Connection Node |
| 4 | First Diode |
| 5 | Second Diode |
| 6 | Third Switching Element |
| 7 | Fourth Switching Element |
| 8 | Bidirectional Switch |
| 81 | First Terminal |
| 82 | Second Terminal |
| 9 | Resonant Capacitor |
| 10 | Switching Circuit |
| 11 | Power Converter Circuit |
| 12 | Regenerative Element |
| 13 | Third Diode |
| 14 | Fourth Diode |
| 15 | Limiter |
| 31 | First DC Terminal |
| 32 | Second DC Terminal |
| 41, 41U, 41V, 41W | AC Terminal |
| 50 | Controller |
| 51 | First Control Unit |
| 52 | Second Control Unit |
| 521 | First Drive Circuit |
| 522 | Second Drive Circuit |
| 100-113 | Power Converter |
| C1 | Capacitor |
| C6 | First Capacitor |
| C7 | Second Capacitor |
| C8 | Capacitor |
| C13 | First Capacitor |
| C14 | Second Capacitor |
| il 1 | Current |
| Ith | Current Threshold Value |
| L1 | Resonant Inductor |
| R1 | First Resistor |
| R2 | Second Resistor |
| R11 | First Resistor |
| R12 | Second Resistor |
| V8 | Voltage |

**Claims**

1. A power converter comprising:

a first DC terminal and a second DC terminal;
a power converter circuit including: a first switching element and a second switching element which are connected to each other in series; a first diode connected in antiparallel to the first switching element; and a second diode

29

connected in antiparallel to the second switching element, the first switching element being connected to the first DC terminal, the second switching element being connected to the second DC terminal;

a bidirectional switch having a first terminal and a second terminal, the bidirectional switch having the first terminal connected to a connection node between the first switching element and the second switching element;

a resonant capacitor connected between the first terminal of the bidirectional switch and the second DC terminal;

a resonant inductor connected to the second terminal of the bidirectional switch;

a regenerative element connected between the resonant inductor and the second DC terminal;

a first control unit configured to control the first switching element and the second switching element;

a second control unit configured to control the bidirectional switch; and

a limiter configured to limit an absolute value of a voltage variation rate of a voltage applied between the first and second terminals of the bidirectional switch to a threshold value or less.

2. The power converter of claim 1, wherein

the bidirectional switch includes a third switching element and a fourth switching element, each of the third switching element and the fourth switching element having a first main terminal, a second main terminal, and a control terminal,
the second control unit includes:

a first drive circuit connected between the control terminal and the second main terminal of the third switching element; and
a second drive circuit connected between the control terminal and the second main terminal of the fourth switching element,
the limiter includes:

a first resistor connected between the control terminal of the third switching element and the first drive circuit; and
a second resistor connected between the control terminal of the fourth switching element and the second drive circuit; and
the limiter is configured to determine in advance a resistance value of the first resistor and a resistance value of the second resistor to make the absolute value of the voltage variation rate when the bidirectional switch turns from OFF to ON equal to or less than the threshold value.

3. The power converter of claim 1, wherein

the bidirectional switch includes a third switching element and a fourth switching element, each of the third switching element and the fourth switching element having a first main terminal, a second main terminal, and a control terminal,
the second control unit includes:

a first drive circuit connected between the control terminal and the second main terminal of the third switching element; and
a second drive circuit connected between the control terminal and the second main terminal of the fourth switching element,
the limiter includes:

a first capacitor connected between the control terminal and the first main terminal of the third switching element; and
a second capacitor connected between the control terminal and the first main terminal of the fourth switching element; and
the limiter is configured to determine in advance a capacitance of the first capacitor and a capacitance of the second capacitor to make the absolute value of the voltage variation rate when the bidirectional switch turns from OFF to ON equal to or less than the threshold value.

4. The power converter of claim 1, wherein

the limiter includes a capacitor connected to the bidirectional switch in parallel, and
the limiter is configured to determine in advance a capacitance of the capacitor to make the absolute value of the voltage variation rate when the bidirectional switch turns from ON to OFF equal to or less than the threshold value.

5. The power converter of claim 1, wherein

the limiter includes a capacitor connected to the resonant inductor in parallel, and
the limiter is configured to determine in advance a capacitance of the capacitor to make the absolute value of the voltage variation rate when the bidirectional switch turns from ON to OFF equal to or less than the threshold value.

6. The power converter of claim 1, further comprising:

a third diode having an anode connected to the connection node between the bidirectional switch and the resonant inductor and having a cathode connected to the first DC terminal; and
a fourth diode having an anode connected to the connection node between the bidirectional switch and the resonant inductor and having a cathode connected to the second DC terminal,
the limiter includes:

a first capacitor connected to the third diode in parallel; and
a second capacitor connected to the fourth diode in parallel, and
the limiter is configured to determine in advance a capacitance of the first capacitor and a capacitance of the second capacitor to make the absolute value of the voltage variation rate when the bidirectional switch turns from ON to OFF equal to or less than the threshold value.

7. The power converter of claim 1, wherein

the resonant inductor has a nonlinear characteristic that makes inductance of the resonant inductor at a value equal to or less than a current threshold value larger than inductance of the resonant inductor at a current value of the resonant current, the current threshold value being less than the current value of a resonant current, and
the resonant inductor is configured to serve as the limiter as well.

8. The power converter of claim 1, wherein

the bidirectional switch includes a third switching element and a fourth switching element which are connected to each other in anti-series, each of the third switching element and the fourth switching element having a first main terminal, a second main terminal, and a control terminal,
each of the third switching element and the fourth switching element is a unipolar transistor,
the second control unit is configured to turn the third switching element and the fourth switching element OFF at a timing when a current flowing through the resonant inductor goes zero, and
the second control unit is configured to serve as the limiter as well.

# FIG. 1

*FIG. 2*

FIG. 3

FIG. 4

## FIG. 5A

## FIG. 5B

## FIG. 6

FIG. 7

*FIG. 8*

FIG. 9

**FIG. 10**

*FIG. 11*

FIG. 12

## FIG. 13

FIG. 14

## FIG. 15

*FIG. 16*

FIG. 17

*FIG. 18*

L1 (15)

L1s     L1r

FIG. 19

## FIG. 20

FIG. 21

**FIG. 22**

FIG. 23

## FIG. 24

## FIG. 25

## FIG. 26

FIG. 27

FIG. 28

## FIG. 29

*FIG. 30*

FIG. 31

## INTERNATIONAL SEARCH REPORT

International application No.

**PCT/JP2023/001144**

### A. CLASSIFICATION OF SUBJECT MATTER

*H02M 7/48*(2007.01)i
FI:   H02M7/48 P; H02M7/48 K

According to International Patent Classification (IPC) or to both national classification and IPC

### B. FIELDS SEARCHED

Minimum documentation searched (classification system followed by classification symbols)

H02M7/42-7/98; H02M3/00-3/44

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2015-181329 A (PANASONIC INTELLECTUAL PROPERTY MANAGEMENT CO., LTD.) 15 October 2015 (2015-10-15) paragraphs [0044]-[0079], [0128], fig. 1, 2, 12 | 1-2 |
| A | | 3-8 |
| A | JP 2011-78204 A (FUJI ELECTRIC SYSTEMS CO., LTD.) 14 April 2011 (2011-04-14) entire text, all drawings | 1-8 |
| A | WO 01/086791 A1 (HITACHI MEDICAL CORP.) 15 November 2001 (2001-11-15) entire text, all drawings | 1-8 |
| A | JP 2002-369553 A (FUJI ELECTRIC CO., LTD.) 20 December 2002 (2002-12-20) entire text, all drawings | 1-8 |

☐ Further documents are listed in the continuation of Box C.     ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **07 March 2023** | **20 March 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
**Information on patent family members**

International application No.

**PCT/JP2023/001144**

| Patent document cited in search report | | | Publication date (day/month/year) | Patent family member(s) | | Publication date (day/month/year) |
|---|---|---|---|---|---|---|
| JP | 2015-181329 | A | 15 October 2015 | US 2015/0256089 A1 paragraphs [0060]-[0095], [0144], fig. 1, 2, 12 | | |
| JP | 2011-78204 | A | 14 April 2011 | (Family: none) | | |
| WO | 01/086791 | A1 | 15 November 2001 | EP 1298780 A1 entire text, all drawings | | |
| JP | 2002-369553 | A | 20 December 2002 | (Family: none) | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010233306 A